(19) Europäisches Patentamt
European Patent Office
Office européen des brevets

(11) EP 2 566 302 B1

(12) **EUROPEAN PATENT SPECIFICATION**

(45) Date of publication and mention of the grant of the patent:
**16.12.2015 Bulletin 2015/51**

(21) Application number: **12005945.6**

(22) Date of filing: **10.08.2001**

(51) Int Cl.:
***H05B 33/14*** (2006.01) ***C09K 11/06*** (2006.01)
***C07D 213/02*** (2006.01) ***C07D 231/10*** (2006.01)
***C07D 241/10*** (2006.01) ***C07D 333/52*** (2006.01)
***C07F 15/00*** (2006.01)

(54) **Organometallic compounds and emission-shifting organic electrophosphorence**

Organometallische Verbindungen und emissionsverlagernde organische Elektrophosphorenz

Composés organométalliques et électrophosphorence organique à changement d'émission

(84) Designated Contracting States:
**AT BE CH CY DE DK ES FI FR GB GR IE IT LI LU MC NL PT SE TR**

(30) Priority: **11.08.2000 US 637766**
**13.04.2001 US 283814 P**

(43) Date of publication of application:
**06.03.2013 Bulletin 2013/10**

(62) Document number(s) of the earlier application(s) in accordance with Art. 76 EPC:
**01962061.6 / 1 325 671**

(73) Proprietors:
- **The Trustees of Princeton University**
**Princeton, NJ 08544 (US)**
- **The University of Southern California**
**Los Angeles, CA 90007-4344 (US)**
- **Universal Display Corporation**
**Ewing, New Jersey 08618 (US)**

(72) Inventors:
- **Lamansky, Sergey**
**Apple Valley, MN 55124 (US)**
- **Thompson, Mark, E.**
**Anaheim, CA 92807 (US)**
- **Adamovich, Vadim**
**Yardley, PA 19067 (US)**
- **Djurovich, Peter, L.**
**Long Beach, CA 90802 (US)**
- **Adachi, Chihaya**
**Chitose, Hokkaido 066-0081 (JP)**
- **Baldo, Marc, A.**
**Cambridge, MA 02142 (US)**
- **Forrest, Stephen**
**Ann Arbor, MI 48104-1857 (US)**
- **Kwong, Raymond, C.**
**Shatin (HK)**

(74) Representative: **Maiwald Patentanwalts GmbH**
**Elisenhof**
**Elisenstrasse 3**
**80335 München (DE)**

(56) References cited:
- **WILDE A P ET AL: "Resolution and analysis of the components in dual emission of mixed-chelate/ ortho-metalate complexes of Iridium (III)", JOURNAL OF PHYSICAL CHEMISTRY, AMERICAN CHEMICAL SOCIETY, US, vol. 95, 1 January 1991 (1991-01-01), pages 629-634, XP002315391, ISSN: 0022-3654**
- **MIRCO G. COLOMBO, HANS U. GUEDEL: "Synthesis and high-resolution optical spectroscopy of bis[2-(2-thienyl)pyridinato-C3,N'](2,2'-bi pyridine)iridium(III)", INORGANIC CHEMISTRY, vol. 32, no. 14, 1993, pages 3081-3087, XP002518211,**
- **MARCO DI G: "A LUMINESCENT IRIDIUM(III) CYCLOMETALLATED COMPLEX IMMOBILIZED IN APOLYMERIC MATRIX AS A SOLID-STATE OXYGEN SENSOR**", ADVANCED MATERIALS, WILEY VCH, WEINHEIM, DE, vol. 8, no. 7, 1 July 1996 (1996-07-01), pages 576-580, XP000598875, ISSN: 0935-9648**
- **FREDERIK W. M. VANHELMONT, MELATH V. RAJASEKHARAN, HANS U. GÜDEL, SILVIA C. CAPELLI, JÜRG HAUSER AND HANS-BEAT BÜRGI: "Influence of electron donor and acceptor substituents on the excited state properties of rhenium(I) tetracarbonyl chelate complexes", J. CHEM. SOC., DALTON TRANS., no. 17, 1998, pages 2893-2900, XP002518212,**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

- WITOLD PAW, SCOTT D. CUMMINGS, M. ADNAN MANSOUR, WILLIAM B. CONNICK, DAVID K. GEIGER, RICHARD EISENBERG: "Luminescent platinum complexes: tuning and using the excited state", COORDINATION CHEMISTRY REVIEWS, vol. 171, no. 1, 1998, pages 125-150, XP002518213,
- CHI-MING CHE, MENGSU YANG, KAR-HO WONG, HING-LEUNG CHAN, WING LAM: "Platinum(II) Complexes of Dipyridophenazine as Metallointercalators for DNA and Potent Cytotoxic Agents against Carcinoma Cell Lines", CHEMISTRY - A EUROPEAN JOURNAL, vol. 5, no. 11, 1999, pages 3350-3356, XP002518214,
- DJUROVICH P I ET AL: "IR(III) CYCLOMETALATED COMPLEXES AS EFFICIENT PHOSPHORESCENT EMITTERS IN POLYMER BLEND AND ORGANIC LEDS", POLYMER PREPRINTS, AMERICAN CHEMICAL SOCIETY, US, vol. 41, no. 1, 1 March 2000 (2000-03-01), page 770/771, XP001052648, ISSN: 0032-3934
- LAMANSKY S ET AL: "Synthesis and Characterization of Phosphorescent Cyclometalated Iridium Complexes", INORGANIC CHEMISTRY, AMERICAN CHEMICAL SOCIETY. EASTON.; US, vol. 40, no. 7, 1 January 2001 (2001-01-01), pages 1704-1711, XP002196399, ISSN: 0020-1669
- LAMANSKY SERGEY ET AL: "Highly phosphorescent bis-cyclometalated iridium complexes: synthesis, photophysical characterization and use in organic light emitting diodes", JOURNAL OF THE AMERICAN CHEMICAL SOCIETY, AMERICAN CHEMICAL SOCIETY, WASHINGTON, DC.; US, US, vol. 123, no. 18, 9 May 2001 (2001-05-09), pages 4304-4312, XP002955894, ISSN: 0002-7863

## Description

### FIELD OF THE INVENTION

The present invention is directed to phosphorescence based organic light emitting devices that have improved electroluminescent characteristics.

### BACKGROUND OF THE INVENTION

The technology of organic light emitting diodes (OLEDs) is undergoing rapid development. OLEDs originally utilized the electroluminescence produced from electrically excited molecules that emitted light from their singlet states. Such radiative emission from a singlet excited state is referred to as fluorescence. More recent work has demonstrated that higher power efficiency OLEDs can be made using molecules that emit light from their triplet state, defined as phosphorescence.

Such electrophosphorescence makes it possible for phosphorescent OLEDs to have substantially higher quantum efficiencies than are possible for OLEDs that only produce fluorescence. This is based on the understanding that the excitons created in an OLED are produced, according to simple statistical arguments as well as experimental measurements, approximately 75% as triplet excitons and 25% as singlet excitons. The triplet excitons more readily transfer their energy to triplet excited states that can produce phosphorescence whereas the singlet excitons typically transfer their energy to singlet excited states that can produce fluorescence. Since the lowest emissive singlet excited state of an organic molecule is typically at a slightly higher energy than the lowest triplet excited state, the singlet excited state may relax, by an intersystem crossing process, to the emissive triplet excited state. This means that all the exciton excitation energy may be converted into triplet state excitation energy, which then becomes available as phosphorescent emission. Thus, electrophosphorescent OLEDs have a theoretical quantum efficiency of 100%, since all the exciton excitation energy can become available as electrophosphorescence.

As a consequence, since the discovery that phosphorescent materials could be used in an OLED, Baldo et al., "Highly Efficient Phosphorescent Emission from Organic Electroluminescent Devices ", Nature, vol. 395, 151-154, 1998, there is now much interest in finding more efficient electrophosphorescent materials.

Typically phosphorescent emission from organic molecules is less common than fluorescent emission. However, phosphorescence can be observed from organic molecules under an appropriate set of conditions. Organic molecules coordinated to lanthanide elements often phosphoresce from excited states localized on the lanthanide metal. The europium diketonate complexes illustrate one group of these types of species. Organic phosphorescence is also often observed in molecules containing heteroatoms with unshared pairs of electrons at very low temperatures. Benzophenone and 2,2'-bipyridine are such molecules. Phosphorescence can be enhanced over fluorescence by confining, preferably through bonding, the organic molecule in close proximity to an atom of high atomic number. This phenomenon, called the heavy atom effect, is created by a mechanism known as spin-orbit coupling. A related phosphorescent transition is a metal-to-ligand charge transfer (MLCT) that is observed in molecules such as tris(2-phenylpyridine)iridium(III).

However, molecules that phosphoresce from MLCT states typically emit light that is of lower energy than that observed from the unbound organic ligand. This lowering of emission energy makes it difficult to develop organic molecules that phosphoresce in the technologically useful blue and green colors of the visible spectrum where the unperturbed phosphorescence typically occurs.

It would be desirable if more efficient electrophosphorescent materials could be found, particularly materials that produce their emission in the blue region of the spectrum.

The realization of highly efficient blue, green and red electrophosphorescence is a requirement for portable full color displays and white lighting applications with low power consumption. Recently, high-efficiency green and red organic electrophosphorescent devices have been demonstrated which harvest both singlet and triplet excitons, leading to internal quantum efficiencies ($\eta_{int}$) approaching 100%. See Baldo, M. A., O'Brien, D. F., You, Y., Shoustikov, A., Sibley, S., Thompson, M. E., and Forrest, S. R., Nature (London), 395,151-154 (1998); Baldo, M. A., Lamansky, S., Burrows, P. E., Thompson, M. E., and Forrest, S. R., Appl. Phys. Lett., 75,4-6 (1999); Adachi, C., Baldo, M. A., and Forrest, S. R., App. Phys. Lett., 77, 904-906, (2000); Adachi, C., Lamansky, S., Baldo, M. A., Kwong, R. C., Thompson, M. E., and Forrest, S. R., App. Phys. Lett., 78, 1622-1624 (2001); and Adachi, C., Baldo, M. A., Thompson, M. E., and Forrest, S. R., Bull. Am. Phys. Soc., 46, 863 (2001). Using a green phosphor, *fac* tris(2-phenylpyridine)iridium ($Ir(ppy)_3$), in particular, an external quantum efficiency ($\eta_{ext}$) of (17.6$\pm$0.5)% corresponding to an internal quantum efficiency of >85%, was realized using a wide energy gap host material, 3-phenyl-4-(1'-naphthyl)-5-phenyl-1,2,4-triazole (TAZ). See Adachi, C., Baldo, M. A., Thompson, M. E., and Forrest, S. R., Bull. Am. Phys. Soc., 46, 863 (2001). Most recently, high-efficiency ($\eta_{ext}$ = (7.0$\pm$0.5)%) red electrophosphorescence was demonstrated employing bis(2-(2'-benzo[4,5-a]thienyl)pyridinato-N, $C^3$) iridium (acetylacetonate) [$Btp_2Ir(acac)$]. See Adachi, C., Lamansky, S., Baldo, M. A., Kwong, R. C., Thompson, M. E., and Forrest, S. R., App. Phys. Lett., 78, 1622-1624 (2001). Wilde et al., J. Phys. Chem. 95,

629-34 (1991); Mirco et al., Inorg. Chem. 32, 3081-7 (1993); Marco et al., Adv. Mater. 8(7), 576-80 (1996); Vanhelmont et al., J. Chem. Soc., Dalton Trans. 2893-900 (1998); Paw et al., Coord. Chem. Rev. 171, 125-50 (1998); Che et al., Chem. Eur. J. 5(11), 3350-6 (1999); and Djurovich et al., Polymer Preprints 41(1), 770-1 (1 March 2000) also disclose luminescent organometallic compounds.

In each of these latter cases, high efficiencies are obtained by energy transfer from both the host singlet and triplet states to the phosphor triplet, or via direct trapping of charge on the phosphor, thereby harvesting up to 100% of the excited states. This is a significant improvement over what can be expected using fluorescence in either small molecule or polymer organic light emitting devices (OLEDs). See Baldo, M. A., O'Brien, D. F., Thompson, M. E., and Forrest, S. R., Phys. Rev., B 60, 14422-14428 (1999); Friend, R. H., Gymer, R. W., Holmes, A. B., Burroughes, J. H., Marks, R. N., Taliani, C., Bradley, D. D. C., Dos Santos, D. A., Bredas, J. L., Logdlund, M., Salaneck, W. R., Nature (London), 397, 121-128 (1999); and Cao, Y, Parker, I. D., Yu, G., Zhang, C., and Heeger, A. J., Nature (London), 397, 414-417 (1999). In either case, these transfers entail a resonant, exothermic process. As the triplet energy of the phosphor increases, it becomes less likely to find an appropriate host with a suitably high energy triplet state. See Baldo, M. A., and Forrest, S. R., Phys. Rev. B 62,10958-10966 (2000). The very large excitonic energies required of the host also suggest that this material layer may not have appropriate energy level alignments with other materials used in an OLED structure, hence resulting in a further reduction in efficiency. To eliminate this competition between the conductive and energy transfer properties of the host, a route to efficient blue electrophosphorescence may involve the endothermic energy transfer from a near resonant excited state of the host to the higher triplet energy of the phosphor. See Baldo, M. A., and Forrest, S. R., Phys. Rev. B 62,10958-10966 (2000); Ford, W. E., Rodgers, M. A. J., J. Phys. Chem., 96,2917-2920 (1992); and Harriman, A.; Hissler, M.; Khatyr, A.; Ziessel, R. Chem. Commun., 735-736 (1999). Provided that the energy required in the transfer is not significantly greater than the thermal energy, this process can be very efficient.

Organic light emitting devices (OLEDs), which make use of thin film materials that emit light when excited by electric current, are expected to become an increasingly popular form of flat panel display technology. This is because OLEDs have a wide variety of potential applications, including cellphones, personal digital assistants (PDAs), computer displays, informational displays in vehicles, television monitors, as well as light sources for general illumination. Due to their bright colors, wide viewing angle, compatibility with full motion video, broad temperature ranges, thin and conformable form factor, low power requirements and the potential for low cost manufacturing processes, OLEDs are seen as a future replacement technology for cathode ray tubes (CRTs) and liquid crystal displays (LCDs), which currently dominate the growing $40 billion annual electronic display market. Due to their high luminous efficiencies, electrophosphorescent OLEDs are seen as having the potential to replace incandescent, and perhaps even fluorescent, lamps for certain types of applications.

Light emission from OLEDs is typically via fluorescence or phosphorescence. As used herein, the term "phosphorescence" refers to emission from a triplet excited state of an organic molecule and the term fluorescence refers to emission from a singlet excited state of an organic molecule.

Successful utilization of phosphorescence holds enormous promise for organic electroluminescent devices. For example, an advantage of phosphorescence is that all excitons (formed by the recombination of holes and electrons in an EL), which are formed either as a singlet or triplet excited state, may participate in luminescence. This is because the lowest singlet excited state of an organic molecule is typically at a slightly higher energy than the lowest triplet excited state. This means that, for typical phosphorescent organometallic compounds, the lowest singlet excited state may rapidly decay to the lowest triplet excited state from which the phosphorescence is produced. In contrast, only a small percentage (about 25%) of excitons in fluorescent devices are capable of producing the fluorescent luminescence that is obtained from a singlet excited state. The remaining excitons in a fluorescent device, which are produced in the lowest triplet excited state of an organic molecule, are typically not capable of being converted into the energetically unfavorable higher singlet excited states from which the fluorescence is produced. This energy, thus, becomes lost to radiationless decay processes that heat-up the device.

## SUMMARY OF THE INVENTION

The present invention is directed to emissive phosphorescent organometallic compounds that produce improved electroluminescence, and organic light emitting devices employing such emissive phosphorescent organometallic compounds. Methods of fabricating such organic light emitting devices are also described herein.

Specific embodiments of the present invention are directed to OLEDs using emissive phosphorescent organometallic compounds that produce improved electrophosphorescence in the blue region of the visible spectrum.

The present invention pertains to:

(1) An organic light emitting device having an emissive layer comprising an organometallic compound, wherein the organometallic compound is selected from the group consisting of:

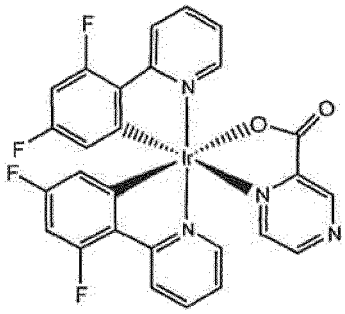

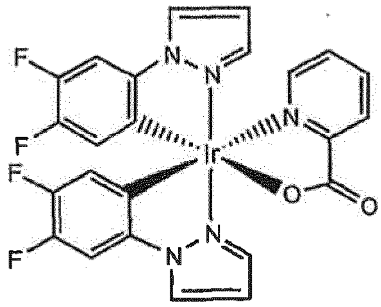

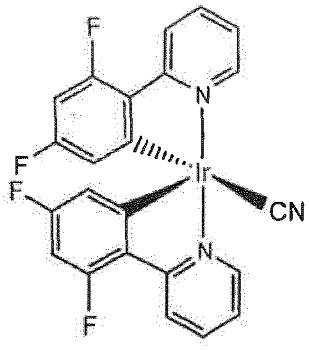

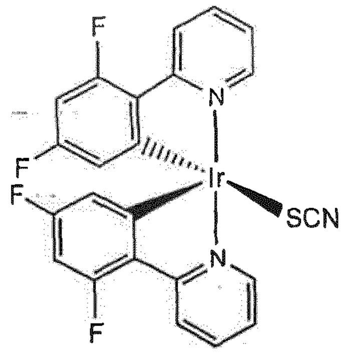

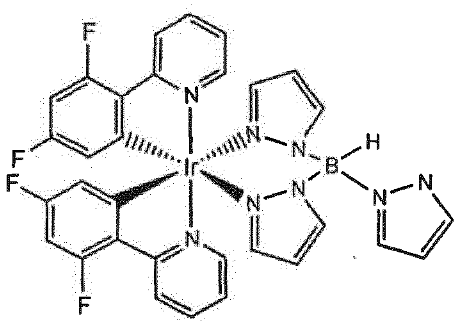

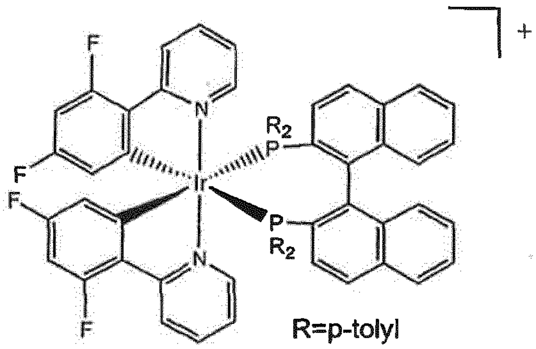

R=p-tolyl

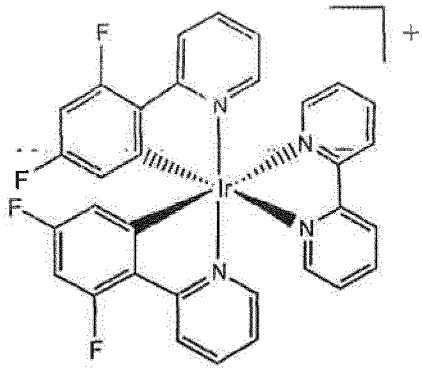

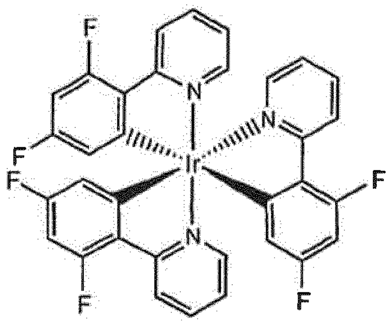

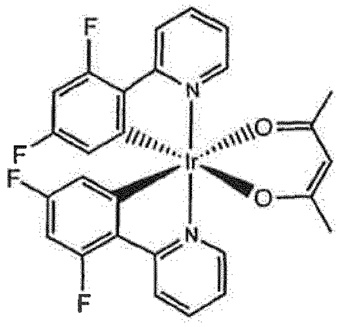

(2) The organic light emitting device of (1), wherein the emissive layer further comprises:

a host material having a lowest triplet excited state having a first decay rate of less than about 1 per second; wherein the organometallic compound is present as a guest material dispersed in the host material, the organometallic compound having a lowest triplet excited state having a radiative decay rate of greater than about $1x10^5$ per second and wherein the energy level of the lowest triplet excited state of the host material is lower than the energy level of the lowest triplet excited state of the organometallic compound.

(3) The organic light emitting device of (1) or (2), wherein the energy difference between the lowest triplet excited state of the organometallic compound and a corresponding relaxed stated of the organometallic compound has a corresponding wavelength of about 420 nm to 480 nm for blue light emission.

(4) The organic light emitting device of (1) or (2), wherein the energy difference between the lowest triplet excited state of the organometallic compound and a corresponding relaxed stated of the organometallic compound has a corresponding wavelength of about 480 nm to 510 nm for aqua-blue light emission.

(5) The organic light emitting device of (1) or (2), wherein the host material has a bandgap with an energy difference corresponding to about 470 nm and the organometallic compound has a lowest triplet excited state at an energy level at about 450 nm.

(6) The organic light emitting device of any one of (1) to (5), wherein the host material is an electron transport layer.

(7) The organic light emitting device of any one of (1) to (6), wherein the host material conducts electrons primarily through hole transmission.

(8) The organic light emitting device of any one of (1) to (7), wherein the ratio of the host material and organometallic compound decay rates is at least about 1:1000 to about 5:1000.

(9) The organic light emitting device of any one of (1) to (8), wherein the host material is TPD.

(10) The organic light emitting device of any one of (1) to (9), wherein a plurality of organometallic compounds are dispersed in the host material.

(11) An organometallic compound selected from the group consisting of:

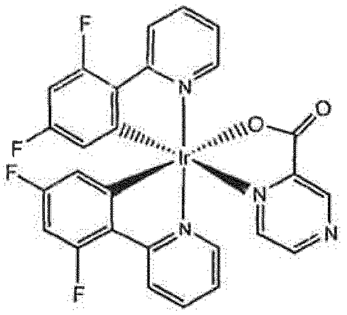
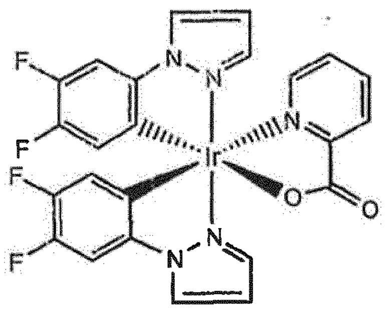

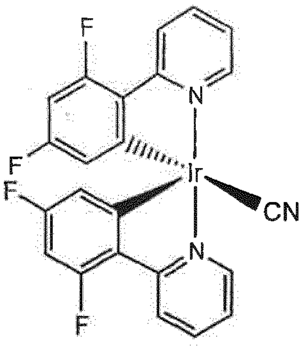
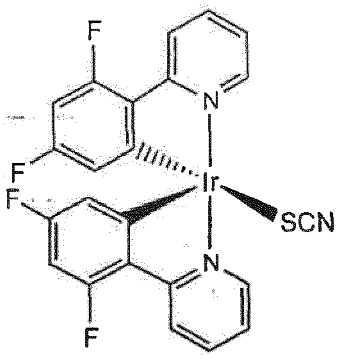

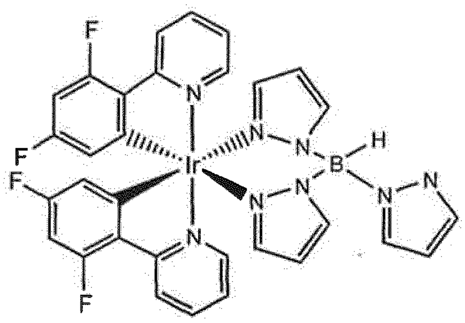
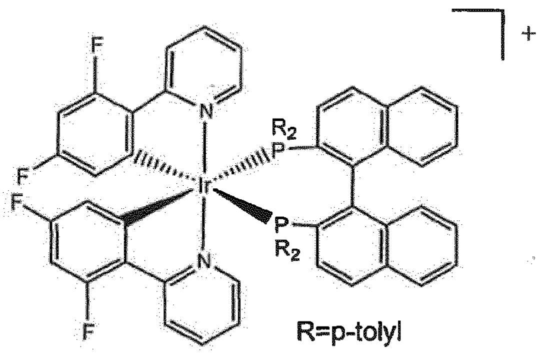

R=p-tolyl

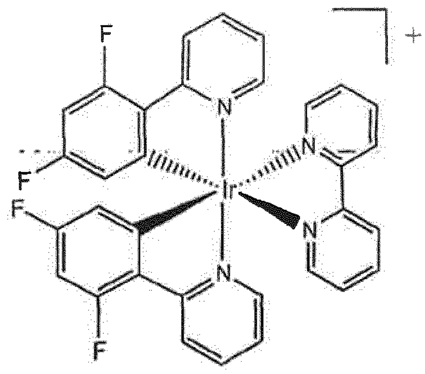

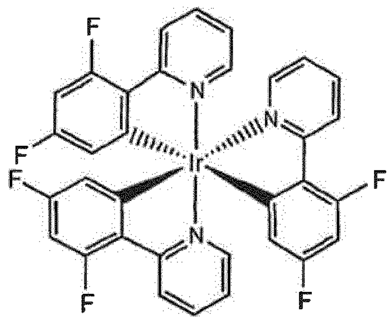

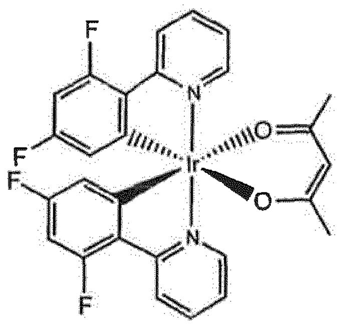

(12) Use of the organometallic compound of (11) in an emissive layer of an organic light emitting diode.

## BRIEF DESCRIPTION OF THE DRAWINGS

Figure 1a shows photoluminescent (PL) spectra in a dilute ($10^{-5}$M) chloroform solution of three different iridium-based phosphors: Iridium(III)bis(4,6-difluorophenyl)-pyridinato-N, $C^{2'}$) picolinate (FIrpic) (curve a); bis (4,6-difluorophenyl)-pyridinato-N, $C^{2'}$)iridium(acetylacetonate) [FIr(acac)] (curve b); and bis(2-phenylpyridinato-N,$C^{2'}$)iridium(acetylacetonate) [$ppy_2Ir(acac)$] (curve c); as well as the molecular structures of these iridium complexes: FIrpic (structure a); FIr(acac) (structure b); and $ppy_2Ir(acac)$ (structure c).

Figure 1b shows shows the electroluminescence spectra of the following OLED structure: ITO/ CuPc (10nm)/ $\alpha$-NPD(30nm)/ CBP host doped with 6% FIrpic (30nm)/ BAlq (30nm)/ LiF (1nm)/ Al (100nm).

Figure 2 shows external electroluminescent quantum ($\eta_{ext}$: filled squares) and power ($\eta_P$: open circles) efficiencies as functions of current density for the following OLED structure: ITO/ CuPc (10nm)/ $\alpha$-NPD(30mn)/ CBP host doped with 6% FIrpic (30nm)/BAlq (30nm)/ LiF (1nm)/ Al (100nm). The inset to Figure 2 shows an energy level diagram of triplet levels of a CBP host and a FIrpic guest.

Figure 3 shows a streak image of the transient decay of a 6%-FIrpic:CBP film (100nm thick) on a Si substrate under nitrogen pulse excitation (~500ps) at T=100K. Also shown is the CBP phosphorescence spectrum obtained at 10K.

Figure 4 shows the transient photoluminescence decay characteristics of a 100nm thick 6%-FIrpic:CBP film on a Si substrate under nitrogen pulse excitation (~500ps) at T=50K, 100K, 200K and 300K. The inset to Figure 4 shows the temperature dependence of the relative photoluminescence (PL) efficiency ($\eta_{PL}$) of FIrpic doped into CBP.

Figures 7h through 7m and 7p through 7r show representative examples of the phosphorescent organometallic compounds of the present invention, along with their emission spectra.

Figure 17 shows the molecular structures of some materials studied for the present description and a view of the triplet dynamics in a guest-host system of the present description.

Figure 18 shows the structure of the electroluminescent devices used to observe the transient response of triplet

diffusion in organic host materials.

Figure 19 shows the phosphorescent spectra of TPD, BCP, CBP and $Ir(ppy)_3$ with PtOEP.

Figure 20 shows the transient response of four model phosphorescent guest-host systems.

## DETAILED DESCRIPTION

The present invention will now be described in detail for specific preferred embodiments of the invention.

The phosphorescent organometallic compounds of the present invention are selected from the group consisting of:

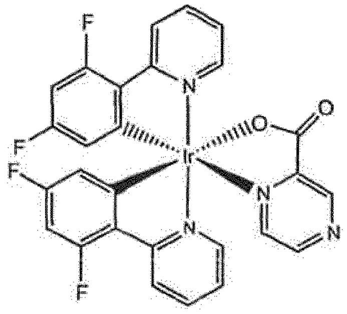

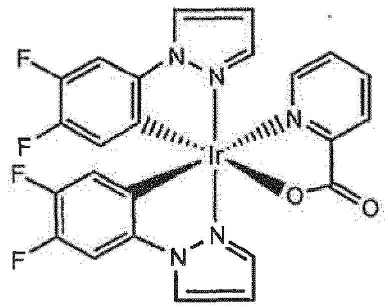

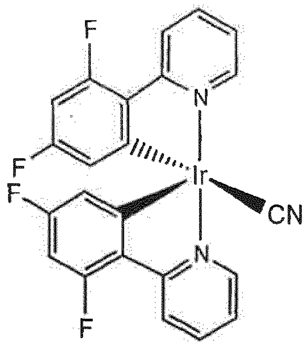

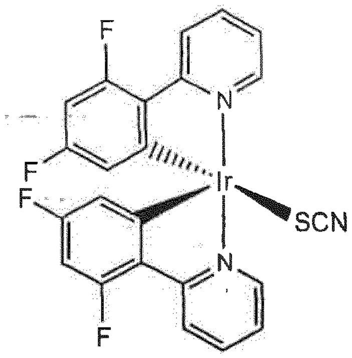

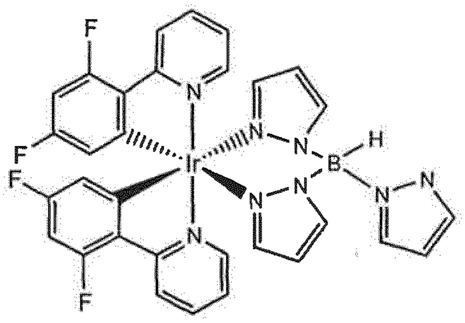

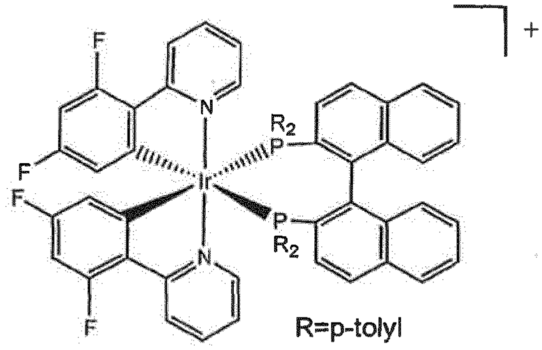

R=p-tolyl

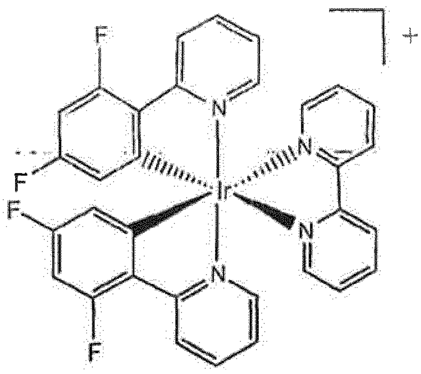

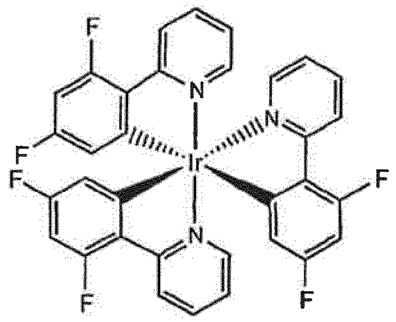

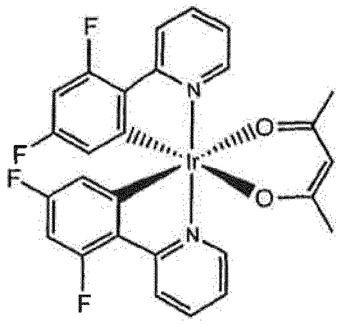

Without intending to be limited to the theory of how the present invention works, it is believed that the improved electroluminescent properties that are observed for the OLEDs of the present invention may be attributed to a combination of factors. For example, it is believed that selection of heavy metals that are capable of forming metal-to-ligand charge transfer (MLCT) states with carbon-coordination ligands that have empty $\pi^*$ orbitals, such phosphorescent materials produce highly efficient electrophosphorescent OLEDs. The electroluminescence from representative organometallic compounds of the present invention shows a vibronic fine structure that indicates that the emission is from an excited state that has a wave function represented by a mixture of the MLCT state of the organometallic compound and the excited triplet state of the carbon-coordination ligand. Since the radiative emission is from a triplet excited state, the emission is referred to as phosphorescence.

It is further believed a higher energy radiative emission may be achieved by including electron-withdrawing groups on a carbon-coordination ligand and/or by selecting a non-carbon-coordination ligand to have a strong electron withdrawing character. Without being limited to the precise theory of how the higher energy radiative emissive may be achieved, it is believed that the electron-withdrawing groups tend to remove electron density from the highest occupied molecular orbitals (HOMO) that include the ligand and the metal atom, thus altering the relative energy levels of the ground state and the excited state such that the overall MLCT transition energy from the ground state to the excited state increases. The preferred organometallic compounds for certain embodiments of the present invention include, thus, strong electron-withdrawing groups on a carbon-coordination ligand and/or non-carbon-coordination ligands having a strong electron-withdrawing character.

The phosphorescent organometallic compounds of the present invention, along with their emission spectra, are shown in Figures 7h - 7m and 7p - 7r.

The preparation of these phosphorescent organometallic compounds of the present invention shown in Figures

7h - 7m and 7p - 7r was accomplished as follows.

**Synthesis of 2-(4,6-difluorophenyl)pyridine**

The 2-(4,6-difluorophenyl)pyridine ligand precursor was prepared by Suzuki coupling of 4,6-difluorophenylboronic acid (Frontier Chemical) with 2-bromopyridine (Aldrich) in 1,2-dimethoxyethane using a $Pd(OAc)_2/PPh_3$ catalyst and $K_2CO_3$ base as per Synlett, 1999, 1, 45-48.

**Synthesis of fac-tris(2-(4,6-difluorophenyl)pyridinato-N,$C^2$) Iridium (III).**

The $Ir(acac)_3$ complex was treated with 6 eq of 2-(4,6-difluorophenyl)pyridine in glycerol at 180°C under inert gas atmosphere for 16 hours. After cooling down to room temperature, water was added to the reaction mixture in order to precipitate the crude product, the solvent was removed under reduced pressure and the crude yellow product was washed with methanol to remove any unreacted picolinic acid. The crude product was flash chromatographed using a silica:dichloromethane column to yield ca. 75% of the pure yellow fac-tris(2-(4,6-difluorophenyl)pyridinato-N,$C^{2'}$) iridium (III) after solvent evaporation and drying.

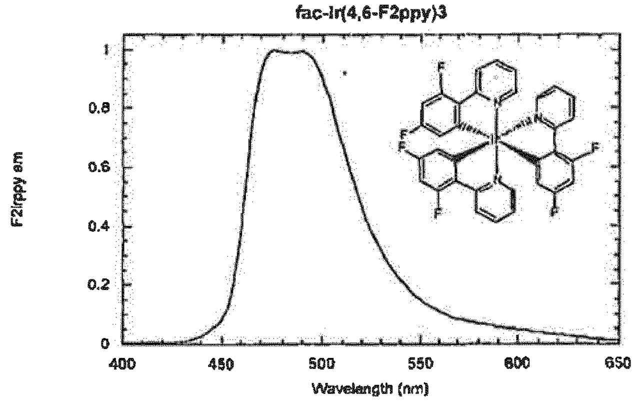


**Synthesis of [(2-(4,6-difluorophenyl)pyridyl)$_2$IrCl]$_2$.**

All procedures involving $IrCl_3{\bullet}H_2O$ or any other Ir(III) species were carried out in inert gas atmosphere in spite of the air stability of the compounds, the main concern being their oxidative stability and stability of intermediate complexes at high temperatures used in the reactions. The cyclometalated Ir(III) $\mu$-chloro bridged dimer of a general formula $C$-$N_2$Ir($\mu$-Cl)$_2$Ir$C$-$N_2$ was synthesized by heating a mixture of $IrCl_3{\bullet}nH_2O$ with 4 eq. of 2-(4,6-difluorophenyl)pyridine) in 2-ethoxyethanol at 130°C for 16 hr. The product was isolated by addition of water followed by filtration and methanol wash. Yield 90%.

**Synthesis of Iridium (III) bis(2-(4,6-difluorophenyl)pyridinato-N,$C^{2'}$)(picolinate).**

The [(2-(4,6-difluorophenyl)pyridyl)$_2$IrCl]$_2$complex was treated with 2 eq of picolinic acid in refluxing 1,2-dichloroethane under inert gas atmosphere for 16 hours. After cooling down to room temperature, the solvent was removed under reduced pressure and the crude yellow product was washed with methanol to remove any unreacted picolinic acid. The crude product was flash chromatographed using a silica:dichloromethane column to yield ca. 75% of the pure yellow ($C$-$N$)$_2$Ir(pic) after solvent evaporation and drying.

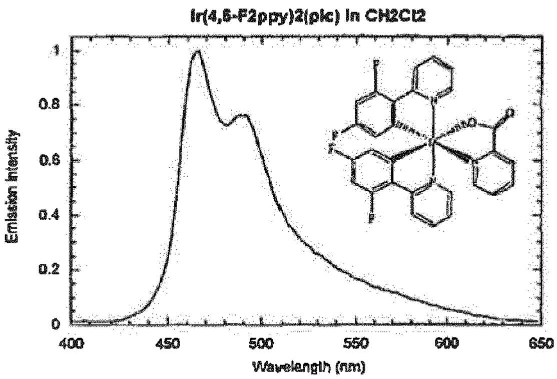


**Synthesis of Iridium (III) bis(2-(4,6-difluorophenyl)pyridinato-N,C$^{2'}$)(acetyl acetonate).**

The [(2-(4,6-difluorophenyl)pyridyl)$_2$IrCl]$_2$complex was treated with 5 eq of 2,4-pentadione and 10 eq of $N_a2CO_3$ in refluxing 1,2-dichloroethane under inert gas atmosphere for 16 hours. After cooling down to room temperature, the solvent was removed under reduced pressure and the crude yellow product was washed with methanol. The crude product was flash chromatographed using a silica:dichloromethane column to , yield ca. 75% of the pure yellow (<u>C-N</u>)$_2$Ir(acac) after solvent evaporation and drying.

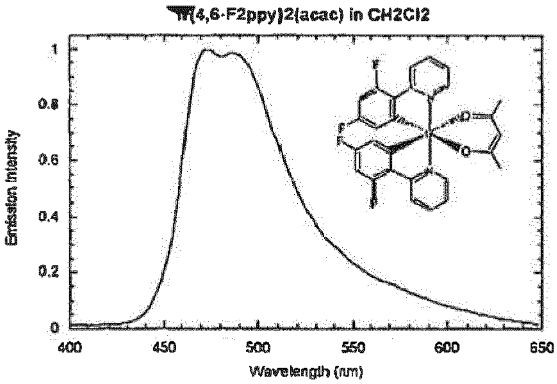


**Synthesis of Iridium (III) bis(2-(4,6-difluorophenyl)pyridinato-N,C$^{2'}$)((R)-(+)-2,2'-bis(dip-tolylphosphino)-1,1'-binaphthyl) chloride.**

The [(2-(4,6-difluorophenyl)pyridyl)$_2$IrCl]$_2$Complex (ca. 0.002 g) was treated with an excess of (R)-(+)-2,2'-bis(di-p-tolylphosphino)-1,1'-binaphthyl in 2 mL $CH_2Cl_2$ solution for 16 hours.

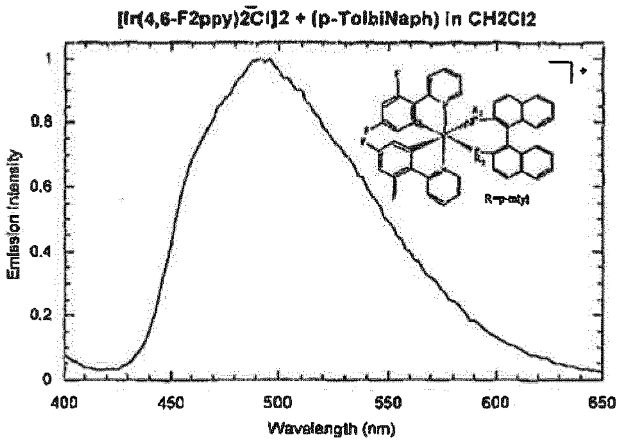

**Synthesis of Iridium (III) bis(2-(4,6-difluorophenyl)pyridinato-N,C2')(2,2'-bipyridine) chloride.**

The [(2-(4,6-difluorophenyl)pyridyl)$_2$IrCl]$_2$complex (ca. 0.002 g) was treated with an excess of 2,2'-bipyridine in 2 mL $CH_2Cl_2$ solution for 16 hours.

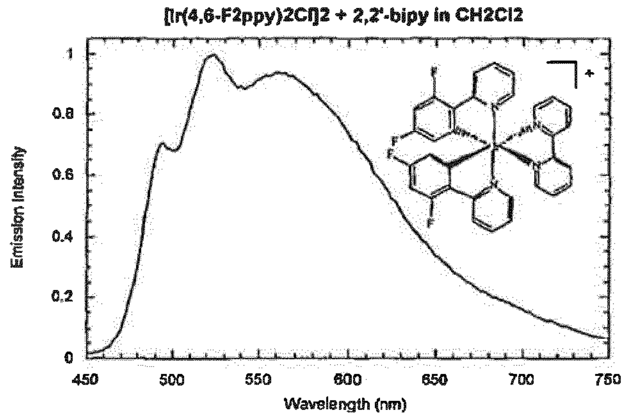


**Synthesis of Iridium (III) bis(2-(4,6-difluorophenyl)pyridinato-N,C2')(pyrazinecarboxylate).**

The [(2-(4,6-difluorophenyl)pyridyl)$_2$IrCl]$_2$complex (ca. 0.002 g) was treated with an excess of pyrazinecarboxylic acid in 2 mL $CH_2Cl_2$ solution for 16 hours.

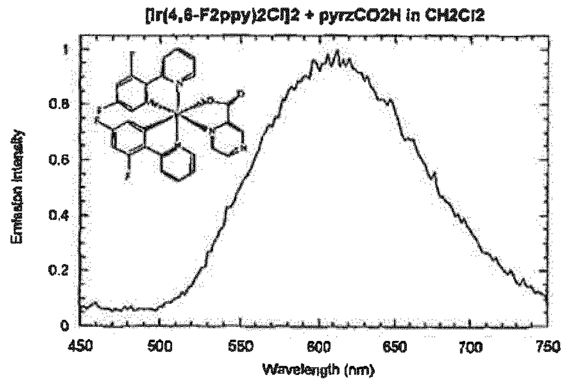


**Synthesis of Iridium (III) bis(2-(4,6-difluorophenyl)pyridinato-N,C2')(tris(pyrazolyl)borate).**

The [(2-(4,6-difluorophenyl)pyridyl)$_2$IrCl]$_2$ complex (ca. 0.002 g) was treated with an excess of potassium tris(pyrazolyl)borate in 2 mL $CH_2Cl_2$ solution for 16 hours.

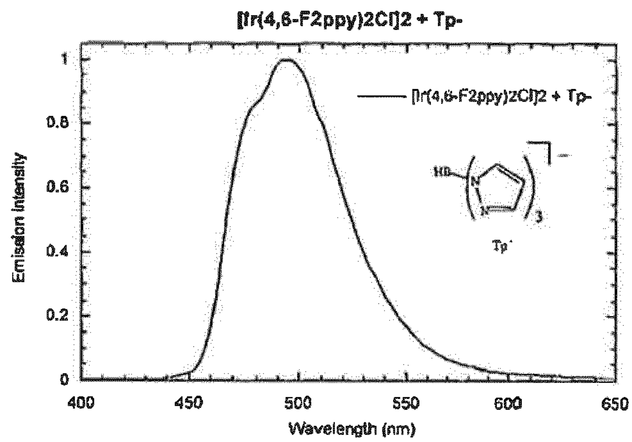

**Synthesis of Iridium (III) bis(2-(4,6-difluorophenyl)pyridinato-N,C2')(cyanide).**

The [(2-(4,6-difluorophenyl)pyridyl)$_2$IrCl]$_2$ complex (ca. 0.002 g) was treated with an excess of potassium cyanide in 2 mL acetone solution for 16 hours.

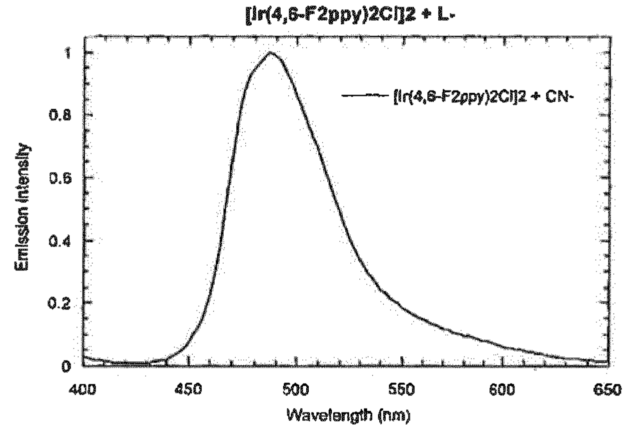


**Synthesis of Iridium (III) bis(2-(4,6-difluorophenyl)pyridinato-N,C2')(thiocyanide).**

The [(2-(4,6-difluorophenyl)pyridyl)$_2$IrCl]$_2$ complex (ca. 0.002 g) was treated with an excess of sodium thiocyanide in 2 mL $CH_2Cl_2$ solution for 16 hours.

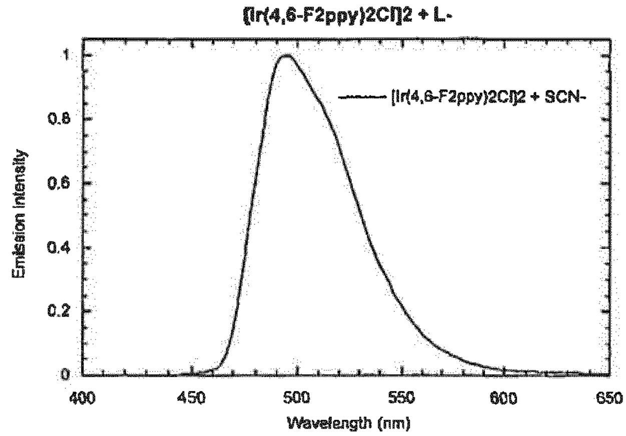


**Synthesis of Iridium (III) bis(1-(4,5-difluorophenyl)pyrazolyl-N,C2')(picolinate).**

The cyclometalated Ir(III) μ-chloro bridged dimer of a general formula $C\text{-}N_2Ir(\mu\text{-}Cl)_2IrC\text{-}N_2$ was synthesized by heating a mixture of $IrCl_3{\bullet}nH_2O$ with 4 eq. of 1-(4,5-difluorophenyl)pyrazole) in 2-ethoxyethanol at 130°C for 16 hr. The crude product was isolated by addition of water followed by filtration and methanol wash. The crude [(1-(4,5-difluorophenyl)pyrazolyl)$_2$IrCl]$_2$ complex was treated with 2 eq of picolinic acid in refluxing 1,2-dichloroethane under inert gas atmosphere for 16 hours. After cooling down to room temperature, the solvent was removed under reduced pressure and the crude yellow product was washed with methanol to remove any unreacted picolinic acid. The crude product was flash chromatographed using a silica:dichloromethane column to yield the pure colorless $(C\text{-}N)_2$Ir(pic) after solvent evaporation and drying.

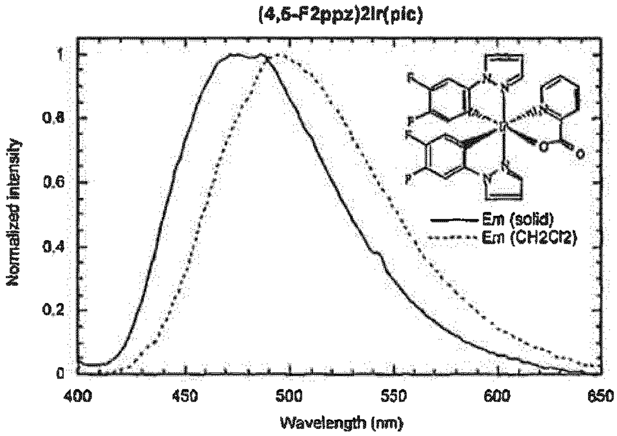


One example of a representative complex not encompassed by the present invention is Iridium(III)bis(4,6-di-fluorophenyl)-pyridinato-N, $C^{2'}$) picolinate (FIrpic), which was used as a phosphorescent dopant in an OLED to produce efficient blue electrophosphorescence. The synthesis of FIrpic is as follows. The 2-(4,6-difluorophenyl)pyridine ligand precursor was prepared by Suzuki coupling of 4,6-difluorophenylboronic acid (Frontier Chemical) with 2-bromopyridine (Aldrich) in 1,2-dimethoxyethane using a $Pd(OAc)_2/PPh_3$ catalyst and $K_2CO_3$ base as per Synlett, 1999,1, 45-48. Next, $[(2\text{-}(4,6\text{-difluorophenyl})pyridyl)_2IrCl]_2$ was synthesized. All procedures involving $IrCl_3 \cdot nH_2O$ or any other Ir(III) species were carried out in inert gas atmosphere in spite of the air stability of the compounds, the main concern being their oxidative stability and stability of intermediate complexes at high temperatures used in the reactions. Cyclometallated Ir(III) di-chloro bridged dimers of a general formula $C\text{-}N_2Ir(mu\text{-}Cl)_2IrC\text{-}N_2$ were synthesized by heating a mixture of $IrCl_3 \cdot H_2O$ (Next Chimica) with 4 eq. of 2-(4,6-difluorophenyl)pyridine) in 2-ethoxyethanol (Aldrich Sigma) at 130°C for 16 hr. The product was isolated by addition of water followed by filtration and methanol wash, resulting in a yield of 90%.

The general procedure for synthesizing $(C\text{-}N)_2Ir(pic)$ complexes is as follows. The $[(C\text{-}N)_2IrCl]_2$ complex was treated with 2 eq. of picolinic acid (Aldrich Sigma) in refluxing 1,2-dichloroethane under inert gas atmosphere for 16 hours. After cooling down to room temperature, the solvent was removed under reduced pressure and the crude yellow product was washed with methanol to remove any unreacted picolinic acid. The crude product was flash chromatographed using a silica:dichloromethane column to yield ca. 75% of the pure yellow $(C\text{-}N)_2Ir(pic)$ after solvent evaporation and drying.

We demonstrated blue electrophosphorescence using energy transfer from a conductive organic host to an iridium complex with two 2-(4,6-difluoro-phenyl)pyridine as two mono-anionic, bidentate, carbon-coordination ligands (cyclometallated) and a picolinate ligand as a non-mono-anionic, bidentate, carbon-coordination ligand. See Lamansky, S., Djurovich, P., Murphy, D., Abdel-Razzaq, F., Adachi, C., Burrows, P. E., Forrest, S. R., and Thompson, M. E., J. Am. Chem. Soc., (in press). The introduction of fluorine groups, which are electron withdrawing substituents, results in an increase of the triplet exciton energy and hence a blue shift of the phosphorescence compared with that of $Ir(ppy)_3$. Using Iridium(III)bis(4,6-di-fluorophenyl)-pyridinato-N, $C^{2'}$) picolinate (FIrpic), we obtained a maximum external quantum EL efficiency ($\eta_{ext}$) of (5.7$\pm$0.3)% and a luminous power efficiency ($\eta_p$) of (6.3$\pm$0.3)lm/W. To our knowledge, this is the first report of efficient blue electrophosphorescence (see Adachi, C., Baldo, M. A., Thompson, M. E., and Forrest, S. R., Material Research Society, Fall Meeting Boston, MA, 1999; Wu, Q. G., Lavigne, J. A., Tao, Y., D'Iorio, M., and Wang, S. N., Inorg. Chem., 39, 5248-5254 (2000); and Ma, Y. G., Lai, T. S., and Wu, Y, Adv. Mat., 12, 433-435 (2000)) and represents a significant improvement of the efficiencies compared with the best blue fluorescent emitters reported to date. See Grice, A. W., Bradley, D. D. C., Bernius, M. T., Inbasekaran, M., Wu, W. W., and Woo, E. P., Appl. Phys. Lett., 73, 629-931 (1998); Hosokawa, C., Higashi, H., Nakamura, H., and Kusumoto, T., Appl. Phys. Lett., 67, 3853-3855 (1995); and Hosokawa, C., Eida, M., Matsuura, M., Fukuoka, K., Nakamura, H., and Kusumoto, T., Synth. Met., 91, 3-7 (1997).

Figure 1a shows photoluminescent (PL) spectra in a dilute ($10^{-5}$M) chloroform solution of three different iridium-based phosphors, bis(2-phenylpyridinato-N,$C^{2'}$)iridium(acetylacetonate) [$ppy_2Ir(acac)$] (curve c), bis (4,6-di-fluorophenyl)-pyridinato-N, $C^{2'}$)iridium(acetylacetonate) [FIr(acac)] (curve b), and FIrpic (curve a), demonstrating a spectral shift with ligand modification. Figure 1a also shows the molecular structures of these iridium complexes: FIrpic (structure a), FIr(acac) (structure b), and $ppy_2Ir(acac)$ (structure c). The presence of the heavy metal iridium results in strong spin-orbit coupling and metal ligand charge transfer, allowing for rapid intersystem crossing of excitons into the radiative triplet manifold. See King, K. A., Spellane, P. J. and Watts, R. J., J. Am. Chem. Soc., 107, 1431-1432 (1985); and Lamansky, S.; Djurovich, P.; Murphy, D.; Abdel-Razzaq, F.; Kwong, R.; Tsyba, L; Bortz, M.; Mui, B.; Bau, R.; Mark E. Thompson, M.E. Inorganic Chemistry,, 40, 1704-1711(2001). All three of these complexes give high photoluminescent efficiencies of $\Phi_{pl}$ = 0.5-0.6 in fluid solution. With the introduction of electron withdrawing fluorine atoms into the 4,6-positions of 2-phenylpyridine, the triplet excited state experiences a blue shift of ~40nm in the PL peak ofFIr(acac), as compared with the green emitting $ppy_2Ir(acac)$. Furthermore, replacement of the acetylacetonate ligand (acac) ofFIr(acac) with picolinate (i.e., FIrpic) resulted in an additional ~20 nm blue shift.

Organic light emitting devices (OLEDs) were grown on a glass substrate precoated with a ~130 nm thick indium-tin-oxide (ITO) layer with a sheet resistance of ~20Ω/□. Prior to organic layer deposition, the substrate was degreased with solvents and cleaned for 5 min by exposure to a UV-ozone ambient, after which it was immediately loaded into the evaporation system. With a base pressure of $\sim 4 \times 10^{-8}$ Torr, the organic and metal cathode layers were grown successively without breaking vacuum using an in *vacuuo* mask exchange mechanism. First, a 10nm-thick copper phthalocyanine (CuPc) hole injection layer followed by a 30nm-thick 4,4'-bis[N-(1-naphthyl)-N-phenylamino]biphenyl (α-NPD) hole transport layer (HTL), respectively, were deposited. Next, a 30nm-thick light-emitting layer (EML) consisting of 6%-FIrpic doped into a 4,4'-N,N'-dicarbazole-biphenyl (CBP) host was prepared via thermal co-deposition. Finally, a 30nm-thick layer of aluminum(III)bis(2-methyl-8-quinolinato)4-phenylphenolate (BAlq) was used to transport and inject electrons into the EML. A shadow mask with rectangular 2mm x 2mm openings was used to define the cathode consisting of a 1 nm-thick LiF layer, followed by a 100nm-thick Al layer. After deposition, the device was encapsulated using a UV-epoxy resin under a nitrogen atmosphere with < 1ppm oxygen and water. We found that carrying out the entire layer deposition process under high vacuum is crucial for obtaining high efficiencies. Given that the peak CBP triplet wavelength (see Baldo, M. A., and Forrest, S. R., Phys. Rev. B 62,10958-10966 (2000)) is $\lambda$=484nm [(2.56±0.10) eV], compared to $\lambda$=475nm [(2.62±0.10) eV] for FIrpic (see spectra in Fig. 3), the endothermic transfer process may be easily interrupted by the presence of nonradiative defect states of intermediate energy. Introduction of oxygen or water may be the source of such defects. Indeed, we have found that breaking vacuum at any point in the fabrication process and exposure to air or purified nitrogen (< lppm oxygen and water) results in a decrease in efficiency of at least a factor of two below the values reported here. A similar ambient sensitivity is not observed for green and red electrophosphorescence OLEDs employing conventional exothermic energy transfer mechanisms.

Figure 1b shows the electroluminescence spectra of the following OLED structure: ITO/ CuPc (10nm)/ α-NPD(30nm)/ CBP host doped with 6% FIrpic (30nm)/BAlq (30nm)/ LiF (1nm)/ Al (100nm). The EL spectrum has a maximum at the peak wavelength of $\lambda_{max}$=475nm and additional sub-peaks at $\lambda_{sub}$=495nm and 540nm (arrows) which generally agrees with the PL spectral shape. The Commission Internationale de L'Eclairage (CIE) coordinates of (x=0.16, y=0.29) for a FIrpic OLED are shown in the inset of Fig. 1b along with the coordinates of green ($Ir(ppy)_3$)(x=0.28, y=0.62) and red ($Btp_2Ir(acac)$)(x=0.67, y=0.33) electrophosphorescence devices. Further tuning of the color purity in the blue through the molecular design of ligands still needs to occur to achieve a closer match to the National Television Standards Committee (NTSC) recommended blue for a video display (lower vertex in the inset).

Figure 2 shows external electroluminescent quantum ($\eta_{ext}$: filled squares) and power ($\eta_P$: open circles) efficiencies as functions of current density for the following OLED structure: ITO/ CuPc (10nm)/ α-NPD(30nm)/ CBP host doped with 6% FIrpic (30nm)/BAlq (30nm)/ LiF (1nm)/ Al (100nm). A maximum $\eta_{ext}$= (5.7±0.3)% (corresponding to an internal efficiency of ~30%) and a luminous power efficiency ($\eta_p$) of (6.3±0.3)lm/W are achieved at J=0.5 mA/cm$^2$ and 0.1 mA/cm$^2$, respectively. While the device shows a gradual decrease in $\eta_{ext}$ with increasing current which has previously been attributed to triplet-triplet annihilation (see Adachi, C., Baldo, M. A., and Forrest, S. R., J. Appl. Phys., 87, 8049-8055 (2000); Baldo, M. A., Adachi, C., and Forrest, S. R., Phys. Rev. B 62, 10967-10977 (2000); and Adachi, C., Kwong, R. C., and Forrest, S. R., Organic Electronics, 2, (2001) (in press)), a maximum luminance of 6400cd/m$^2$ with $\eta_{ext}$=3.0% was obtained even at a high current of J=100mA/cm$^2$. These values compare favorably with $\eta_{ext}$ = 2.4% for fluorescent devices with a similar blue color emission spectrum. See Hosokawa, C., Higashi, H., Nakamura, H., and Kusumoto, T., Appl. Phys. Lett., 67, 3853-3855 (1995). The inset to Figure 2 shows an energy level diagram of triplet levels of a CBP host and a FIrpic guest. Due to the energy lineup of CBP and FIrpic triplet levels, both exothermic and endothermic transfer can be possible. Here, $\kappa_g$ and $\kappa_h$ are the radiative decay rates of triplets on the guest (phosphor) and host molecules, and the rates of exothermic (forward) ($\kappa_F$) and endothermic (reverse) ($\kappa_R$) energy transfers between CBP and FIrpic is also indicated. Since the triplet energy level of a CBP host (2.56±0.10) eV is slightly less than that of FIrpic at (2.62±0.10) eV (inset of Fig. 2), exothermic energy transfer from FIrpic to CBP is inferred. Note that the pronounced roll-off at small J is uncharacteristic of conventional electrophosphorescence. This is indicative of the sensitivity of backward energy transfer to the presence of energy dissipative pathways, reducing the efficiency via nonradiative triplet recombination when the density of triplets is too low to saturate these parasitic mechanisms. In addition, unbalanced hole and electron injection into EML can also account for the roll off.

Figure 3 shows a streak image of the transient decay of a 6%-FIrpic:CBP film (100nm thick) on a Si substrate under nitrogen pulse excitation (~500ps) at T=100K. Two distinct decay processes, prompt and delayed phosphorescence, are demonstrated along with their photoluminescent spectra: dashed line=prompt and solid line=delayed. Also shown is the CBP phosphorescence spectrum obtained at 10K. In addition to the prompt phosphorescence of FIrpic, we observe an extremely long decay component lasting for $\tau$~10ms which follows the CBP triplet lifetime. The prompt phosphorescence has a lifetime somewhat shorter than the solution phosphorescence lifetime of FIrpic (2 μsec). Since the PL spectrum of the slow component coincides with that of FIrpic PL, this supports the conclusion that exothermic

energy transfer from FIrpic to CBP occurs. The triplet state then migrates through the CBP host molecules and finally is endothermally transferred back to FIrpic, resulting in the delayed phosphorescence observed. Due to the significant difference of lifetimes of the excited states, $\kappa_h << \kappa_g$, ($\kappa_h$ and $\kappa_g$ are the radiative decay rates of the triplets on the host and guest molecules, respectively), the triplet exciton decay originates from FIrpic, as desired. Here, the low intensity blue emission centered at $\lambda_{max}$=400nm in the prompt emission spectrum is due to fluorescence of CBP, with a transient lifetime <<100ns which is significantly shorter than the transient decay of FIrpic. A similar process has been observed for energy transfer from the pyrene triplet to a Ru MLCT excited state, leading to long Ru-MLCT excited state lifetimes. See Ford, W. E., Rodgers, M. A. J., J. Phys. Chem., 96, 2917-2920 (1992); Harriman, A.; Hissler, M.; Khatyr, A.; Ziessel, R. Chem. Commun., 735-736 (1999).

Figure 4 shows the transient photoluminescence decay characteristics of a 100nm thick 6%-FIrpic:CBP film on a Si substrate under nitrogen pulse excitation (~500ps) at T=50K, 100K, 200K and 300K. The inset to Figure 4 shows the temperature dependence of the relative photoluminescence (PL) efficiency ($\eta_{PL}$) of FIrpic doped into CBP. After a slight enhancement of $\eta_{PL}$ as temperature is increased from 50K to 200K, it once again decreases at yet higher temperatures. The transient decay characteristics are also temperature dependent. In particular, a significant decrease in the nonexponential decay time was observed at T=50K and 100K. The enhancement of $\eta_{PL}$ from T=300K to 200K is due to the suppression of nonradiative decay of FIrpic. The decrease of $\eta_{PL}$ below T~200K, however, is a signature of retardation of the endothermic process of energy transfer from CBP to FIrpic, leading to loss of the radiative triplet excitons. Since we observe no delayed component at T=300K, energy transfer from CBP to FIrpic is very efficient with thermal assistance. In contrast, the PL intensity of $Ir(ppy)_3$:CBP shows no temperature dependence along with no evidence for such a slow component at low temperature, suggesting the absence of backward energy transfer in that low triplet energy guest system.

As discussed above, we have herein demonstrated efficient blue electrophosphorescence using FIrpic as the phosphor molecule. Due to the comparable energy of the phosphor triplet state relative to that of the 4,4'-N,N'-dicarbazole-biphenyl (CBP) conductive host molecule into which it is doped, the exothermic transfer of energy from phosphor to host, and subsequent endothermic transfer from host back to phosphor is clearly observed. Using this triplet energy transfer process, we force emission from the higher energy, blue triplet state of the phosphor. The existence of endothermic energy transfer is confirmed by the low temperature phosphorescent spectra of CBP and FIrpic, and the appearance of a maximum in the photoluminescent intensity of CBP:FIrpic at T~200K. Employing this process, a very high maximum external quantum efficiency of (5.7$\pm$0.3) % and a luminous power efficiency of (6.3$\pm$0.3)lm/W are achieved. The electroluminescent (EL) spectrum has a maximum at a wavelength of $\lambda_{max}$=470nm with additional peaks at $\lambda_{sub}$=495nm and 540nm, leading to the Commission Internationale de L'Eclairage (CIE) coordinates of x=0.16 and y=0.29.

Other methods known to those skilled in the art of fabricating OLEDs may be used.

Since the discovery that phosphorescent materials can be used as the emissive material in highly efficient OLEDs, there is now much interest in finding still more efficient electrophosphorescent materials and OLED structures containing such materials. High efficiency organic light emitting devices (OLEDs) using the phosphorescent dopant, *fac* tris(2-phenylpyridine)iridium ($Ir(ppy)_3$), have been demonstrated using several different conducting host materials. See, for example, M. A. Baldo et al., Nature, vol. 395, 151 (1998); D. F. O'Brien et al., Appl. Phys. Lett., vol. 74, 442 (1999); M. A. Baldo et al., Appl. Phys. Lett., vol. 75, 4 (1999); T. Tsutsui et al., Japanese. J. Appl. Phys., Part 2, vol. 38, L1502 (1999); C. Adachi et al., App. Phys. Lett., vol. 77, 904 (2000); M. J. Yang et al., Japanese J. Appl. Phys., Part 2, vol. 39, L828 (2000); and C. L. Lee et al., Appl. Phys. Lett., vol. 77, 2280 (2000). Since the triplet level of the metal-ligand charge transfer state of the green-emitting $Ir(ppy)_3$ is between 2.5 eV and 3.0 eV, deep blue fluorophores with a peak wavelength at about 400 nm, such as 4,4'-*N*,*N*'-dicarbazole-biphenyl (CBP), are likely candidates as triplet energy transfer and exciton confining media. Using 6% to 10%-$Ir(ppy)_3$ in CBP leads to efficient $Ir(ppy)_3$ phosphorescence. In addition to the energetic resonance between the dopant and the host, the control of charge carrier injection and transport in the host layers is believed to be necessary for achieving efficient formation of radiative excitons. High electrophosphorescence efficiency has been achieved using $Ir(ppy)_3$ doped into CBP along with a 2,9-dimethyl-4,7-diphenyl-phenanthroline (BCP) electron transport and exciton blocking layer. M.A. Baldo et al., Appl. Phys. Lett., vol. 75, 4 (1999). In that device, the doped CBP layer was found to readily transport holes.

The compound 4,4',4"-tris(3-methylphenylphenylamino)triphenylamine ("m-MTDATA") was disclosed for use as a hole injecting material in electroluminescent OLEDs in which fluorescence was obtained from an electron transporting layer comprised of tris(8-hydroxyquinoline)aluminum ("$Alq_3$"). See Shirota et al., Appl. Phys. Lett., vol.65, no. 7, 807 (1994).

Four processes determine the overall efficiency of energy transfer between a host and a guest molecule: the rates of exciton relaxation on the guest and host, $k_G$ and $k_H$, respectively, and the forward and reverse triplet transfer rates between guest and host, $k_F$ and $k_R$, respectively. The rate equations, in the absence of exciton-formation processes, are

$$\frac{dG}{dt} = -k_G G - k_R G + k_p H,$$
$$\frac{dH}{dt} = -k_H H - k_p H + k_R G, \quad (1)$$

where G and H are the densities of guest and host triplet excitons. The solutions to equation (1) are biexponential decays of the form

$$G, H = A_1 \exp[k_1 t] + A_2 \exp[-k_2 t], \quad (2)$$

In a model OLED containing $Ir(ppy)_3$ (not encompassed by the present invention) as organometallic compound, the materials used are (a) $N_1N$'-diphenyl-$N_1$-bis(3-methylphenyl)-[1,1-biphenyl]-4,4'-diamine (TPD), (b) 2,9-dimethyl-4,7-diphenyl-1,10-phenanthroline(bathocuproine or BCP), (c) 4,4'-N,N'-dicarbzaole-biphenyl (CBP), (d) $Alq_3$, (e) *fac* tris (2-phenylpyridine) iridium [$Ir(ppy)_3$] and (f) 2,3,7,8,12,13,17,18-octaethyl-21H,23H-porphine platinum(II) (PrOEP). Of these materials, TPD and CBP are predominantly hole-transport and $Alq_3$ and BCP are electron-transport materials. Two phosphors are also employed as guests, $Irx(ppy)_3$, which emits at ~510 nm which a phosphorescent lifetime of -0.4$\mu$s, id and PrOEP, which emits at 650 nm with a phosphorescent lifetime: of - 100$\mu s^3$.

Faster phosphorescent rates can produce better emission results. An embodiment of the present invention concerns, among other things, the following relationship: k_phos * exp (-delta_G/kT) > k_host. The k_phos is the phosphorescence rate, that is preferably greater than about 1 x $10^5$ /sec and/or 1 x $10^6$/sec. The delta_G is the difference in free energy, which in this case is substantially equal to the energy difference between the host and the guest triplets. The kT is the thermal energy and is about 0.025 eV at typical device operating temperatures. The k_host is the host decay rate; the k_host may be equivalent to the radiative and nonradiative decay rates, equaling less than about 5 x $10^3$ /sec. Thus, within the relationship identified, namely, k_phos * exp (delta_G/kT) > k_host, if k_phos is about 1 x $10^5$ /sec, kT is about 0.025 eV, and k_host is about 5 x $10^3$ /sec, then delta_G is less than about 0.075 eV. An outer boundary for delta_G in this particular case can be that delta_G is less than about .17 eV. The outerlimit decision can be made in reference to the type of host material being used due to such factors as stability. Also, hosts with larger triplet energy levels can increase the device voltage.

Further, the overall triplet decay rate should not be too small in order to minimize other losses. E.g., k_phos is about 1 x $10^6$/sec, k_host is about 1 x $10^3$ /sec and delta_G is less than about 0.17 eV. Or, k_phos is about 1 x $10^5$ /sec, k_host is about 5 x $10^3$ /sec and delta_G is less than about 0.17 eV. Preferably, k_phos is about 1 x $10^6$ /sec, k_host is about 1 x $10^3$ /sec and delta_G is less than about .075 eV.

Fig. 17 shows the molecular structures of the materials studied: (a) TPD (N,N'-diphenyl-N,N'-bis(3-merhylphenyl)-[1,1'-biphenyl]4,4'-diamine), (b) BCP (2, 9-dimethyl-4,7-diphenyl-1, 10-phenanthroline), (c) CBP (4.4'-N.N'-dicarbazole-bipphenyl), (d) $Alq_3$ tris(8-hydroxyquinoline) aluminum, (c) $Ir(ppy)_3$ *fac* tris(2-phenylpyridine)iridium (a model organometallic compound not encompassed by the present invention), and (f) PtOEP 2, 3, 7, 8, 12, 13, 17, 18-octaethyl-21H.23H-porphine platinum(II). Fig. 17(g) further shows the triplet dynamics in a guest host system of the present invention. Fig. 17(g) shows the rates of forward and back transfer, $k_F$ and $k_G$, respectively, which are determined by the Gibb's free energy change ($\Delta$G) and the molecular overlap. The rates of decay from the guest and host triplet states are labeled $k_G$ and $k_H$, respectively.

The simplified OLED structures of the present invention are demonstrated herein for OLED structures in which the organic hole trapping material is a phosphorescent emissive guest material for which the emission is produced from a triplet excited state of an organic molecule.

In Fig. 18, the structure of the electroluminescent devices is used to observe the transient response of triplet diffusion in organic host materials. Electron and hole transport layers are labeled ETL and HTL, respectively. The highest occupied molecular orbital (HOMO) obtained for each material corresponds to its ionization potential (IP). The lowest unoccupied molecular orbital (LUMO) is equal to the IP plus the optical energy gap, as determined from absorption spectra. Relative alignments of the energies in the fully assembled devices will differ from those shown. Two devices are shown: in Fig. 18(a) the host preferentially transports electrons and the exciton formation zone is at the interface between the host and $\alpha$-NPD; in Fig. 18(b) the host preferentially transports holes and exciton formation is at the interface between the host and BCP. In both devices triplets are forced to diffuse through the host before reaching a phosphorescent dye. Singlets formed during electrical excitation cause fluorescence within the host, thus triplet dynamics are reflected in the delay between fluorescence and phosphorescence.

For electroluminescent devices employing $Alq_3$ as the host, the exciton-formation zone is located at the interface

of the HTL and $Alq_3$. In the case of HTL host materials, the exciton-formation zone is at the interface between the HTL and BCP. To study exciton diffusion, undoped layers of the host material were inserted between the exciton-formation interface and a phosphorescent layer. As shown in Fig. 18, triplets are forced to diffuse through this undoped zone before being captured by the doped luminescent, or "triplet sensing," layer.

Also shown in Fig. 18 are proposed energy levels for the host and guest materials. The electron energy levels referenced to vacuum are indicated by the lowest unoccupied molecular orbital (LUMO) and the energy levels of holes are given by the highest occupied molecular orbitals (HOMO), as determined from the ionization potential for each material. It may be assumed here that the HOMO-LUMO gap is equal to the optical energy gap, as determined from absorption spectra. Under this assumption, the LUMO does nor necessarily serve as the lowest conduction level for mobile electrons. Although not shown here, charge redistributions and polarization effects at the heterointerfaces are expected to alter the relative energy-level alignments when differing materials are brought into contact.

The triplet energies, measured from the highest energy peak of the PL spectra, and decay lifetimes are summarized in Table I. From the triplet energies, the free energy change $\Delta G$ on triplet transfer can be calculated for combinations of host and guest materials. Given the guest materials PtOEP and $Ir(ppy)_3$ (both model organometallic compounds which are not embodiments of the present invention), it is possible to categorize several host and guest combinations based on the magnitude and sign of $\Delta G$ (see Fig. 17).

The efficiency of phosphorescence depends on the creation rates of triplets on the host and guest species. For example, it the bulk of excitons are formed on the guest molecular species, then efficient phosphorescence may be possible even though triplets are only weakly confined. Therefore, to understand a particular electrophosphorescent guest-host system, we need to know the site of exciton formation. This may be determined by analysis of the phosphorescent transients. The phosphorescent material in the structures of Fig. 18 can be displaced from the exciton formation zone, forcing triplets to diffuse across several hundred angstroms of organic material prior to recombination. To measure the diffusion time, we first apply a short electrical pulse and generate singlet and triplet excitons at the ETL/HTL interface. The formation of excitons follows the current transient and is observed by measuring transient fluorescence from singlets in the host material. Then after the electrical excitation has ceased, the delay between the fluorescence and the onset of phosphorescence is measured. Either charge or triplet diffusion may be responsible for the delay, but charge diffusion can be effectively "turned off' by applying reverse bias following the excitation pulse to discharge traps and sweep out the remaining charge. Therefore, if similar delayed phosphorescence is observed in the presence and absence of reverse bias, then charge trapping on guest molecules must be significant. See Table I.

Table I. Material triplet energies and room temperature triplet lifetimes.

| Material | Triplet energy ($\pm$ 0.1 eV) | Triplet lifetime |
|---|---|---|
| PtOEP | 1.9 | 1.10 $\pm$ 10$\mu$s |
| $Ir(ppy)_3$ | 2.4 | 0.8 $\pm$ 0.1 $\mu$s |
| CBP | 2.6 | >1s |
| BCP | 2.5 | < 10 $\mu$s |
| TPD | 2.3 | 200 $\pm$ 50 $\mu$s |
| $Alq_3$ | 2.0 | 25 $\pm$ 15 $\mu$s |

Since the probability of triplet transfer is proportional to the product of the electron and hole transfer probabilities, it is expected that triplet diffusion occurs at a slower rate than charge transport. However, even in cases where charge diffusion dominates the phosphorescent decay, there still may be additional triplet diffusion time. For example, the delay in the triplet transport or the various species may diffuse over different distances prior to localization on a phosphorescent molecule. Hence, in those systems where delayed phosphorescence is eliminated by reverse bias, it can be concluded that charge trapping is significant, but it is possible that rapid triplet diffusion also occurs.

Unlike fluorescent guest-host systems, the phosphorescent systems summarized in Table II do not require energy transfer from guest to host (i.e. $\Delta G$ <0). Given minimal triplet losses in the host, the only relaxation pathway may be phosphorescence from the guest, and, as is observed in $Ir(ppy)_3$ in TPD, the overall electroluminescent quantum efficiency of phosphorescent OLED's with $\Delta G$ <0 can be as high as 3%. In such a system, the excitons reside primarily on the host and are eventually transferred to phosphorescent guest sites prior to emission. Although guest-host combinations with $\Delta G$ <0 generally exhibit superior performance by minimizing losses at the host, systems with $\Delta G$ <0 may be useful for high energy triplet emitters such as blue phosphors.

Similar to $Ir(ppy)_3$ in TPD, triplet diffusion from host to guest is observed for PtOEP in $Alq_3$. From transient analyses of exciton transport in $Alq_3$. From transient analyses of exciton transport in $Alq_3$, it is likely that the transport

is dispersive with behavior similar to charge transport. Nevertheless, in approximating it as a nondispersive system, we obtain a diffusion coefficient of D $r$ = (8 ± 5) X $10^{-8}cm^{2/5}$ and triplet lifetime of $r$ = (25 ± 15) μs.

TABLE II. The electrophosphorescent quantum efficiencies and several properties of a range of material combinations.

| Guest (lifetime) | Host | ΔG (± 0.1 eV) | Host lifetime | Emission lifetime (μs) | Trapping on guest | El quantum efficiency |
|---|---|---|---|---|---|---|
| PtOEP (110 ± 10 μs) | CBP | -0.7 | >1 s | 80 ± 5 | Yes | 6% |
| | $Ir(ppy)_3$ | -0.5 | <0.1 μs | 80±5 | ? | 3% |
| | TPD | -0.4 | 200 ±50 μs | 80 ± 5 | Yes | 3% |
| | $Alq_3$ | -0.1 | 25± 15 μs | 40± 5 | No | 3% |
| $Ir(ppy)_3$(0.8± 0.1 μs) | CBP | -0.2 | >1 s | 0.4± 0.50 | Yes | 8% |
| | TPD | +0.1 | 200±50 μs | 15± 2 | No | 3% |
| | $Alq_3$ | +0.4 | 25± 15 μs | <0.1 | ? | <0.1% |

All the guest-host systems employing the green phosphor $Ir(ppy)_3$ exhibit weak triplet confinement on the phosphorescent guest, i.e., ΔG ~0. Indeed, reverse transfer from $Ir(ppy)_3$ to CBP is undoubtedly responsible for some losses in luminescence efficiency and the decrease in phosphorescent lifetime from -0.8 to -0.4 μs. In spite of this, external quantum efficiencies as high as 8% have been obtained from $Ir(ppy)_3$ doped in CBP.[4] As confirmed by the transient studies here, these efficiencies are possible because a majority of excitons are formed directly on $Ir(ppy)_3$ following charge trapping. The deep HOMO level of CBP, in particular, appears to encourage hole trapping on phosphorescent guest. But there remains significant room for improvement, and at least a further doubling of phosphorescent efficiency should be possible given the right host material.

The deposition techniques for any of the above-listed layers and materials are well-known in the art. For example, a representative method of depositing the OLED layers is by thermal evaporation or spin coating if a polymer LED is used; a representative method of depositing metal layers is by thermal or electron-beam evaporation; and a representative method of depositing indium tin oxide is by electron-beam evaporation or sputtering.

The present invention may also be used to provide stable, efficient, high brightness, monochromatic, multicolor, or full-color, flat panel displays of any size. The images created on such displays could be text or illustrations in full-color, in any resolution depending on the size of the individual OLEDs. Display devices made with an OLED of the present invention are therefore appropriate for an extremely wide variety of applications including billboards and signs, computer monitors, and telecommunications devices such as telephones, televisions, large area wall screens, theater screens and stadium screens. The structures described herein are included, for example, in a plurality of pixels in a light emitting device or as part of a single-pixel, flat panel backlight device. Moreover, the structures described herein may be used as part of a laser device. Because of the exceptionally high luminous efficiencies that are possible for phosphorescent-based OLEDs, as compared with OLEDs generally, and especially with respect to conventional inorganic LEDs, the phosphorescent-based OLEDs of the present invention may also be used as a light source for illumination applications. Such light sources could replace conventional incandescent or fluorescent lamps for certain types of illumination applications. Such phosphorescence-based OLEDs could be used, for example, in large planar light sources that produce illumination of a desired color.

If the host material is an electron transporter, then it is used as an electron transport layer (ETL) and employed in the structure of Fig. 18(a). Of the host materials used, $Alq_3$ and BCP films may serve as an ETL; the remaining materials are predominantly hole conductors and can be used in hole-transport layers (HTL's). For these materials, a wide-energy-gap bole and exciton-blocking material are required to contain the excitations within the HTL. For this purpose, we used BCP in structures shown in Fig. 18(b). BCP can conduct electrons but blocks holes from entering the ETL.

The devices were fabricated by thermal evaporation of the source materials under high vacuum (≈ $10^{-6}$ Torr). In successive evaporations, a hole-transport material was deposited on a precleaned glass substrate coated with ITO. This was followed by deposition of the host material. Since the host was also an HTL, a 120 Å thick BCP blocking layer was employed. All devices employed an $Alq_3$ ETL to separate the emissive region from the 1000-Å- thick 20:1 Mg:Ag cathode, thereby positioning the luminescent region more favorably within the microcavity created by the metal cathode. The devices were completed by depositing a 500-Å-thick layer of Ag to protect the Mg-Ag cathode from oxidation. Metal

depositions were defined by a shadow mask with an array of 1-mm-diameter openings.

Transient measurements were obtained by applying a narrow (200-ns) voltage pulse to the device under test and coupling the emission into a streak camera. This pulse width is chosen to be less than the radiative rate of the phosphors and larger than the charging time of the OLED, which for a 50-'Ω load and a typical capacitance of 1 nF is about 50 ns. In some cases, the sample was placed under -10 V reverse bias following the electrical pulse. External EL quantum efficiency measurements were made by placing the completed OLED directly onto the surface of a calibrated silicon photodetector and capturing every photon emitted in the forward (viewing) direction. All measurements were performed in air, except for those at low-temperature which were performed in an evacuated closed-cycle refrigerator.

The host materials, TPD, CBP, and $Alq_3$ are fluorescent and possess small or negligible phosphorescence at room temperature due to competing thermally activated nonradiative decay processes. In addition to intramolecular pathways, these nonradiative processes include triplet diffusion to defect sites followed by dissipative transitions. Reducing the temperature slows the rate of phonon-assisted decay and triplet diffusion, and the phosphorescent PL spectra for TPD, CBP, and BCP at T= 10 K are shown in Fig. 19 together with the room-temperature spectra of PtOEP and $Ir(ppy)_3$. After extended sampling, it was possible to obtain the room-temperature phosphorescent spectra and lifetimes for TPD and CBP. These measurements were possible because the triplet lifetimes of these materials are relatively long at room temperature: 200± 50μs and >1 s, respectively. In fact, under ultraviolet excitation, weak orange CBP phosphorescence is visible to the naked eye at room temperature. In contrast, the triplet lifetime of BCP decreases rapidly as temperature increases from ~1 s at 10 K to <10 μs at room temperature, although we note that short triplet lifetimes may be dominated by energy transfer to physical or chemical defects.

No phosphorescence was observed from $Alq_3$ even at temperatures as low as - 10 K. In their study of hydroxyquinoline complexes, Ballardini *et al.*, were similarly unsuccessful in observing phosphorescent emission from $Alq_3$, although they could observe the phosphorescent spectra of hydroxyquinoline complexes as Pb, Bi, Rh, Ir, and Pt. These latter materials all show triplet emission at 590-650 nm and while it is not certain that the triplet energy of $Alq_3$ also lies within this range, it seems likely that it is significantly red-shifted from the spectra of the other host materials in Fig. 19.

In Fig. 20, the transient responses of four model electrophosphorescent material systems are shown. The device in Fig. 20(a) consists of a 600-A-thick $Alq_3$ diffusion layer and a phosphorescent sensing layer of 8% PtOEP doped in $Alq_3$ (8% PtOEP:$Alq_3$). The PtOEP: $Alq_3$ transients clearly exhibit delayed phosphorescence due to triplet diffusion in $Alq_3$ and also show minimal change when reverse bias is applied to the empty traps. However, in Fig. 20(b) we observe that a similar structure using a 8% PtLOEP:CEP emission layer fails to show delayed phosphorescence when reverse bias is applied. When reverse bias is absent, the decay lifetime is increased due to the transport of electrons across the 400-A-thick diffusion layer, see Fig. 20(d). Here, the observed lifetime of $Ir(ppy)_3$ is ~15 μs, significantly longer than its natural radiative decay of 1 μs. Taken together with the apparent absence of charge trapping on $Ir(ppy)_3$ in TPD to $Ir(ppy)_3$ is the rate limiting step in $Ir(ppy)_3$ phosphorescence.

All systems exhibit delayed phosphorescence in the absence of reverse bias; however, only (a) PtOEP: $Alq_3$ and (d) $Ir(ppy)_3$ =TPD delayed phosphorescence in the presence of a strong negative bias. Thus, we conclude that triplet energy transfer is present in these systems but that the other systems. (b) PtOEP:CBP and (c) $Ir(ppy)_3$: CBP, are dominated by charge trapping and exciton formation directly upon the phosphorescent molecular indeed, the deep HOMO level of CBP makes hole trapping on the guest likely when it is used as a host. In Sec. VII of the article entitled *Transient analysis of organic electrophosphoresence: I Transient analysis of triplet energy transfer,* M. A. Baldo and S.R. Forrest, Physical Review B, vol. 62, no. 16, (2000) we discuss the relative merits of trapping and energy transfer as mechanisms for generating very high efficiency phosphorescent emission in OLEDs. But in the remainder of this and the following section we concentrate on those systems exhibiting energy transfer: notably, PtOEP: $Alq_3$ and $Ir(ppy)_3$: TPD.

In Fig. 20(d), the peak in the delayed phosphorescence of $Ir(ppy)_3$: TPD occurs over 100 μs after excitation. If we examine the transient of an $Ir(ppy)_3$: TPD device where there is no layer separating the excitron-formation interface from the luminescent zones, we find that delayed phosphorescence is absent and that the observed lifetime after electrical excitation is 15 ± 2μ s (see Fig. 21(a)). Except for an initial peak containing some TPD fluorescence the decay is monoexponential and completely comprised of $Ir(ppy)_3$ emission. The PL decay of 10% $Ir(ppy)_3$: TPD also exhibits long-lived differs in that the initial peak is larger than that found in the EL decay, and no emission is observed from TPD.

The data of Figs. 20(d), 21 (a), and 21(b) are to be compared with the natural phosphorescent lifetime of $Ir(ppy)_3$ which is only 1 μs. As expected from the relative phosphorescent spectra and lifetimes of TPD and $Ir(ppy)_3$, these data can be explained by triplets residing for extended periods on TPD molecules. The rate of forward transfer ($k_F$) is slow (~15 μs) and dominates the phosphorescent lifetime of $Ir(ppy)_3$ in TPD. We note that because the observed 15 μs $Ir(ppy)_3$ EL decay is also observed in the PL response, there must be significant populations of triplets in TPD after photoexcitation, i.e., $k_R$»$k_F$. The EL quantum efficiency of $Ir(ppy)_3$ in TPD is η~3%, providing evidence that efficient electrophosphorescence is possible even if it is energetically unfavorable for triplets to reside for an extended duration on the phosphor.

In Fig. 20, the transient response of four archetypal phosphorescent guest-host systems is shown. The PtOEP transients were recorded at λ=650 ± 10 nm and the $Ir(ppy)_3$ transients at λ=530 ± 30 nm. The initial peaks in the

transient decays are host fluorescence at the wave lengths of interest they mark the formation of singlet excitons. Triplet energy transfer is demonstrated in (a) by PtOEP: $Alq_3$. These transients exhibit strong delayed phosphorescence due to triplet diffusion in $Alq_3$ and also show minimal change when reverse bias is applied to empty traps. This device had a 600-A-tick $Alq_3$ diffusion layer and a phosphorescent sensing layer of 8% PtOEP in $Alq_3$. However, in (b) we observe that PtOEP: CBP fails to show delayed phosphorescence when reverse bias is applied, indicating that charge trapping on PtOEP is significant. This device had a 400-A-thick CBP diffusion layer and a phosphorescent sensing layer of 8% PtOEP in CBP. Similarly, in (c) the transient response of $Ir(ppy)_3$:CBP also exhibits charge trapping on $Ir(ppy)_3$. This device had a 500-A-thick CBP diffusion layer and a phosphorescent sensing layer of 6% $Ir(ppy)_3$ in CBP. Energy transfer to $Ir(ppy)_3$ is observed in $Ir(ppy)_3$: TPD (d). Here, the observed lifetime of $Ir(ppy)_3$ is 15 $\mu$s significantly longer than its natural radiative lifetime of 1 $\mu$s. Taken together with the apparent absence of charge trapping on $Ir(ppy)_3$ in TPD, this long lifetime indicates that energy transfer from TPD to $Ir(ppy)_3$ might be the rate limiting step in $Ir(ppy)_3$ phosphorescence. This device had a 200-A-thick TPD diffusion layer and a phosphorescent sensing layer of 6% $Ir(ppy)_3$ in TPD. Note that the intensity of each transient measurement is arbitrary.

Another organic light emitting device of the present invention includes an organic light emitting layer wherein the energy difference between the lowest triplet excited state of the organometallic compound as guest material and a corresponding relaxed state of the organometallic compound as guest material has a corresponding wavelength of about 420 nm to 480 nm for blue light emission.

Another organic light emitting device of the present invention includes an organic light emitting layer wherein the energy difference between the lowest triplet excited state of the organometallic compound as guest material and a corresponding relaxed state of the organometallic compound as guest material has a corresponding wavelength of about 480 nm - 510 nm for aqua-blue light emission.

Another organic light emitting device of the present invention includes an organic light emitting layer wherein the host material has a bandgap with an energy difference corresponding to about 470 nm and the organometallic compound as guest material has a lowest triplet excited state at an energy level at about 450 nm.

Another organic light emitting device of the present invention includes an organic light emitting layer wherein a plurality of organometallic compound as guest materials are dispersed in the host material.

According to the present invention, the peak in the phosphorescent blue emission is preferably produced at a wavelength of $\leq$ 470 nm.

## Claims

1. An organic light emitting device having an emissive layer comprising an organometallic compound, wherein the organometallic compound is selected from the group consisting of:

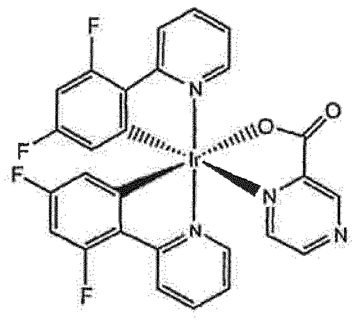

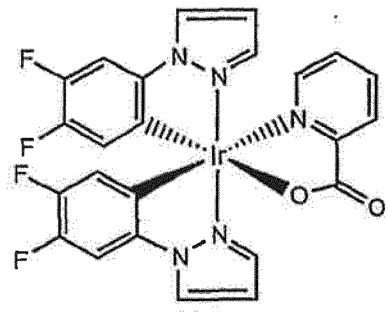

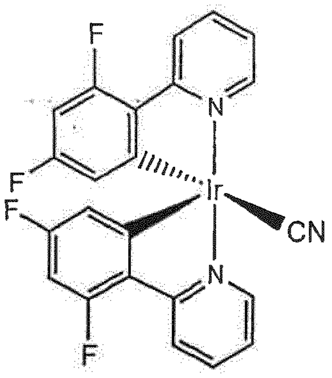

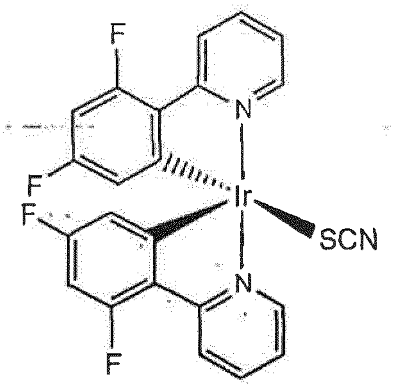

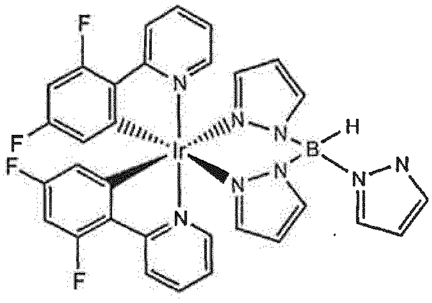

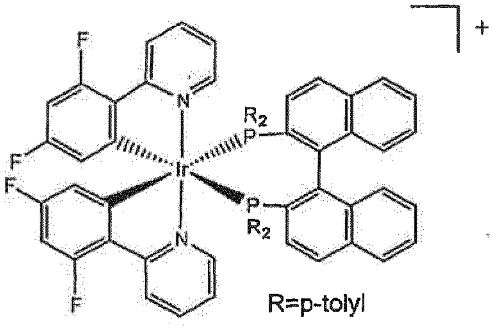

R=p-tolyl

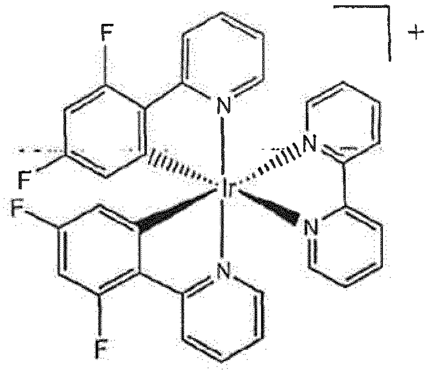

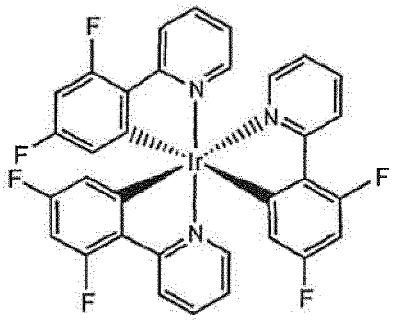

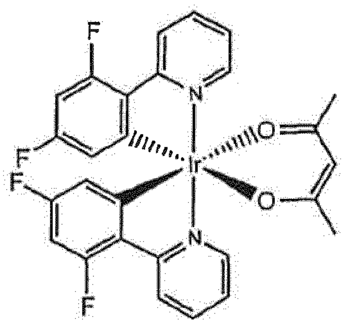

2. The organic light emitting device of claim 1, wherein the emissive layer further comprises:

a host material having a lowest triplet excited state having a first decay rate of less than about 1 per second; wherein the organometallic compound is present as a guest material dispersed in the host material, the organometallic compound having a lowest triplet excited state having a radiative decay rate of greater than about $1x10^5$ per second and wherein the energy level of the lowest triplet excited state of the host material is lower than the energy level of the lowest triplet excited state of the organometallic compound.

3. The organic light emitting device of claim 1 or 2, wherein the energy difference between the lowest triplet excited state of the organometallic compound and a corresponding relaxed stated of the organometallic compound has a corresponding wavelength of about 420 nm to 480 nm for blue light emission.

4. The organic light emitting device of claim 1 or 2, wherein the energy difference between the lowest triplet excited state of the organometallic compound and a corresponding relaxed state of the organometallic compound has a corresponding wavelength of about 480 nm to 510 nm for aqua-blue light emission.

5. The organic light emitting device of claim 1 or 2, wherein the host material has a bandgap with an energy difference corresponding to about 470 nm and the organometallic compound has a lowest triplet excited state at an energy level at about 450 nm.

6. The organic light emitting device of any one of claims 1 to 5, wherein the host material is an electron transport layer.

7. The organic light emitting device of any one of claims 1 to 6, wherein the host material conducts electrons primarily through hole transmission.

8. The organic light emitting device of any one of claims 1 to 7, wherein the ratio of the host material and organometallic compound decay rates is at least about 1:1000 to about 5:1000.

9. The organic light emitting device of any one of claims 1 to 8, wherein the host material is TPD.

10. The organic light emitting device of any one of claims 1 to 9, wherein a plurality of organometallic compounds are dispersed in the host material.

11. An organometallic compound as defined in claim 1.

12. Use of the organometallic compound of claim 11 in an emissive layer of an organic light emitting diode.

**Patentansprüche**

1. Eine organische lichtemittierende Vorrichtung mit einer emittierenden Schicht enthaltend eine organometallische Verbindung, wobei die organometallische Verbindung ausgewählt ist aus der Gruppe bestehend aus:

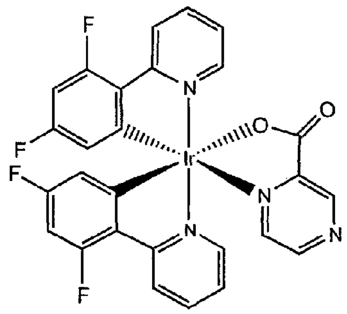

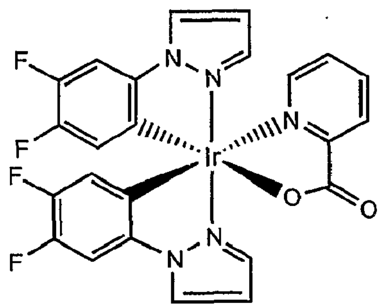

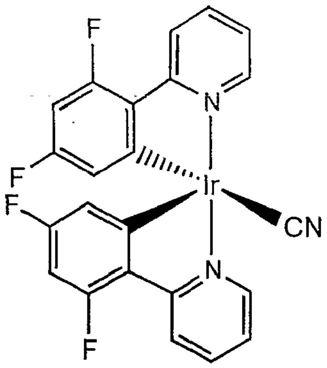

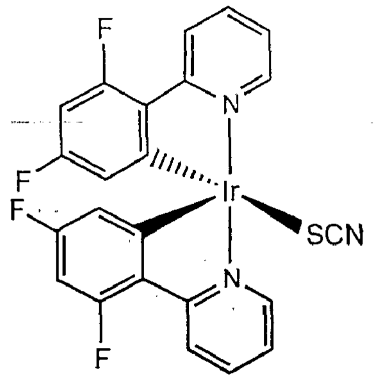

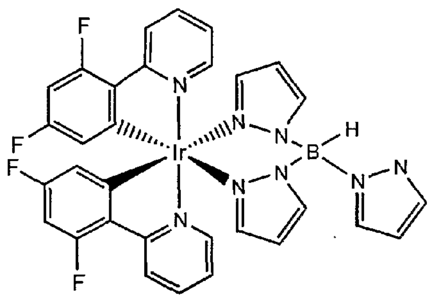

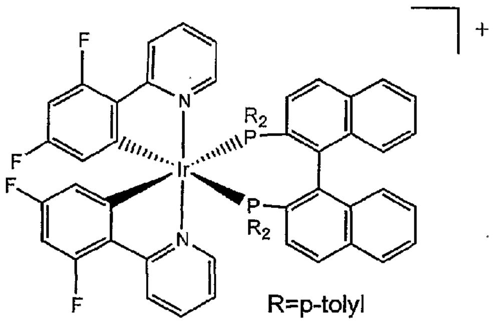

R=p-tolyl

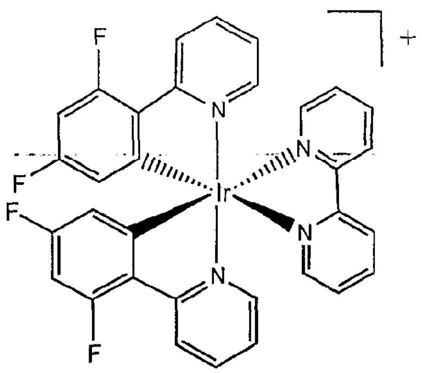

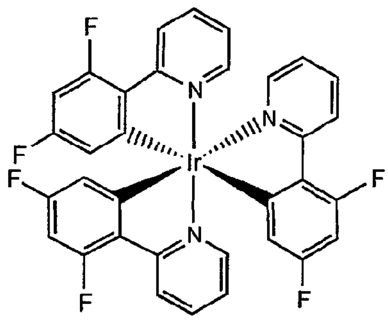

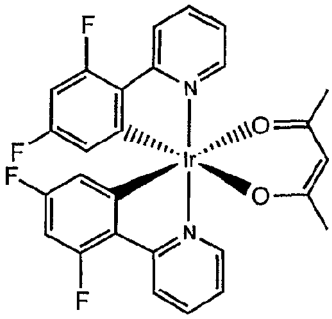

2. Die organische lichtemittierende Vorrichtung gemäß Anspruch 1, wobei die emittierende Schicht des Weiteren enthält:

Ein Wirtsmaterial mit einem niedrigsten Triplett-Anregungszustand, der eine erste Zerfallsrate von weniger als etwa 1 pro Sekunde hat; wobei die organometallische Verbindung als ein im Wirtsmaterial verteiltes Gastmaterial vorhanden ist, wobei die organometallische Verbindung einen niedrigsten Triplett-Anregungszustand hat, welcher eine Strahlungszerfallsrate von mehr als etwa $1x10^5$ pro Sekunde hat, und wobei das Energieniveau des niedrigsten Triplett-Anregungszustands des Wirtsmaterials niedriger ist als das Energieniveau des niedrigsten Triplett-Anregungszustands der organometallischen Verbindung.

3. Die organische lichtemittierende Vorrichtung gemäß Anspruch 1 oder 2, wobei die Energiedifferenz zwischen dem niedrigsten Triplett-Anregungszustand der organometallischen Verbindung und einem entsprechenden relaxierten Zustand der organometallischen Verbindung eine entsprechende Wellenlänge von etwa 420 nm bis 480 nm für Emission von blauem Licht hat.

4. Die organische lichtemittierende Vorrichtung gemäß Anspruch 1 oder 2, wobei die Energiedifferenz zwischen dem niedrigsten Triplett-Anregungszustand der organometallischen Verbindung und einem entsprechenden relaxierten Zustand der organometallischen Verbindung eine entsprechende Wellenlänge von etwa 480 nm bis 510 nm für Emission von wasserblauem Licht hat.

5. Die organische lichtemittierende Vorrichtung gemäß Anspruch 1 oder 2, wobei das Wirtsmaterial eine Bandlücke mit einer Energiedifferenz hat, die etwa 470 nm entspricht, und die organometallische Verbindung einen niedrigsten Triplett-Anregungszustand auf einem Energieniveau von etwa 450 nm hat.

6. Die organische lichtemittierende Vorrichtung gemäß irgendeinem der Ansprüche 1 bis 5, wobei das Wirtsmaterial eine elektronentransportierende Schicht ist.

7. Die organische lichtemittierende Vorrichtung gemäß irgendeinem der Ansprüche 1 bis 6, wobei das Wirtsmaterial Elektronen hauptsächlich über Lochübertragung leitet.

8. Die organische lichtemittierende Vorrichtung gemäß irgendeinem der Ansprüche 1 bis 7, wobei das Verhältnis zwischen den Zerfallsraten des Wirtsmaterials und der organometallischen Verbindung wenigstens etwa 1:1000 bis etwa 5:1000 beträgt.

9. Die organische lichtemittierende Vorrichtung gemäß irgendeinem der Ansprüche 1 bis 8, wobei das Wirtsmaterial TPD ist.

10. Die organische lichtemittierende Vorrichtung gemäß irgendeinem der Ansprüche 1 bis 9, wobei eine Vielzahl von organometallischen Verbindungen im Wirtsmaterial verteilt ist.

11. Eine organometallische Verbindung wie in Anspruch 1 definiert.

12. Verwendung der organometallischen Verbindung gemäß Anspruch 11 in einer emittierenden Schicht von einer organischen Leuchtdiode.

**Revendications**

1. Dispositif électroluminescent organique ayant une couche émissive comportant un composé organométallique, dans lequel le composé organométallique est choisi parmi le groupe constitué de :

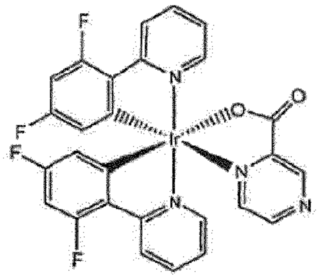
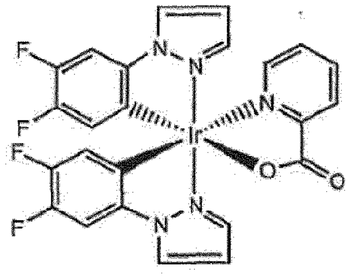

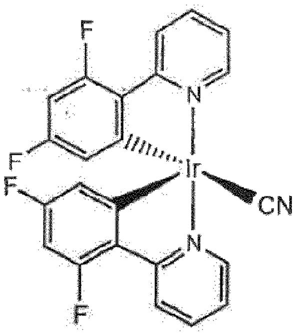
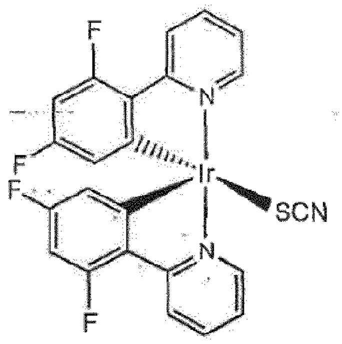

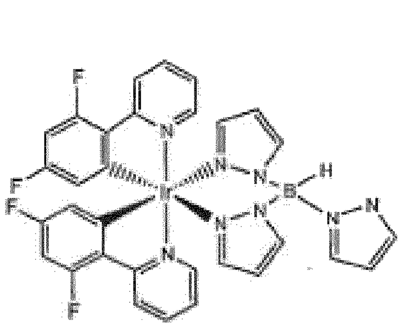
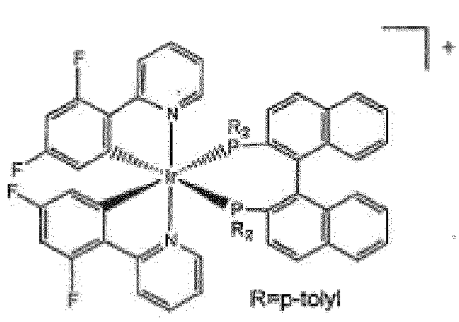

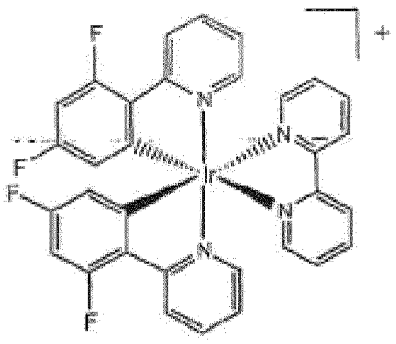

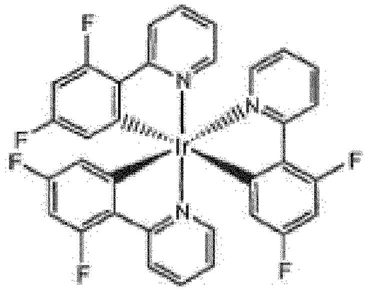

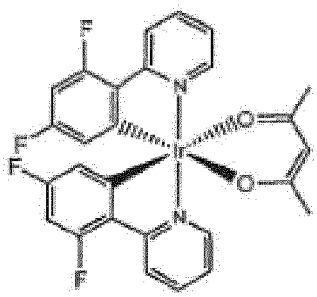

**2.** Dispositif électroluminescent organique selon la revendication 1, dans lequel la couche émissive comporte en outre :

un matériau hôte ayant un état excité triplet le plus bas ayant une première vitesse de désexcitation inférieure à environ 1 par seconde, dans lequel le composé organométallique est présent sous la forme d'un matériau invité dispersé dans le matériau hôte, le composé organométallique ayant l'état excité triplet le plus bas ayant une vitesse de désexcitation radiative supérieure à environ $1\times10^5$ par seconde et dans lequel le niveau d'énergie de l'état excité du triplé le plus bas du matériau hôte est inférieur au niveau d'énergie de l'état excité triplet le plus bas du composé organométallique.

**3.** Dispositif électroluminescent organique selon la revendication 1 ou 2, dans lequel la différence d'énergie entre l'état excité triplet le plus bas du composé organométallique et un état relaxé correspondant du composé organométallique a une longueur d'onde correspondante d'environ 420 nm à 480 nm pour l'émission de lumière bleue.

**4.** Dispositif électroluminescent organique selon la revendication 1 ou 2, dans lequel la différence d'énergie entre l'état excité triplet le plus bas du composé organométallique et un état relaxé correspondant du composé organométallique a une longueur d'onde correspondante d'environ 480 nm à 510 nm pour l'émission de lumière bleu aqua.

**5.** Dispositif électroluminescent organique selon la revendication 1 ou 2, dans lequel le matériau hôte a une bande interdite avec une différence d'énergie correspondant à environ 470 nm et le composé organométallique a un état excité triplet le plus bas à un niveau d'énergie d'environ 450 nm.

**6.** Dispositif électroluminescent organique selon l'une quelconque des revendications 1 à 5, dans lequel le matériau hôte est une couche de transport d'électrons.

**7.** Dispositif électroluminescent organique selon l'une quelconque des revendications 1 à 6, dans lequel le matériau hôte conduit des électrons principalement par une transmission à travers des trous.

**8.** Dispositif électroluminescent organique selon l'une quelconque des revendications 1 à 7, dans lequel le rapport des vitesses de désexcitation du matériau hôte et du composé organométallique est d'au moins environ 1:1000 à environ 5:1000.

**9.** Dispositif électroluminescent organique selon l'une quelconque des revendications 1 à 8, dans lequel le matériau hôte est la TPD.

**10.** Dispositif électroluminescent organique selon l'une quelconque des revendications 1 à 9, dans lequel une pluralité de composés organométalliques est dispersée dans le matériau hôte.

**11.** Composé organométallique tel que défini dans la revendication 1.

**12.** Utilisation du composé organométallique selon la revendication 11 dans une couche émissive d'une diode électroluminescente organique.

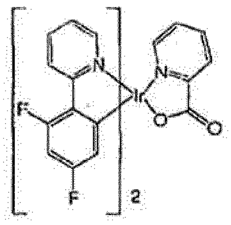

(a)

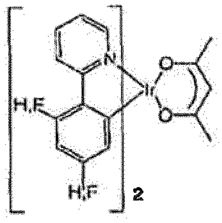

(b) F, (c) H

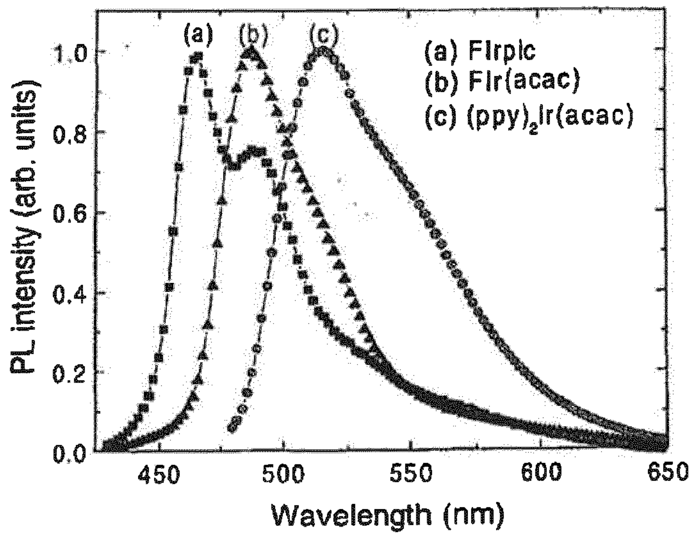


Figure 1a:

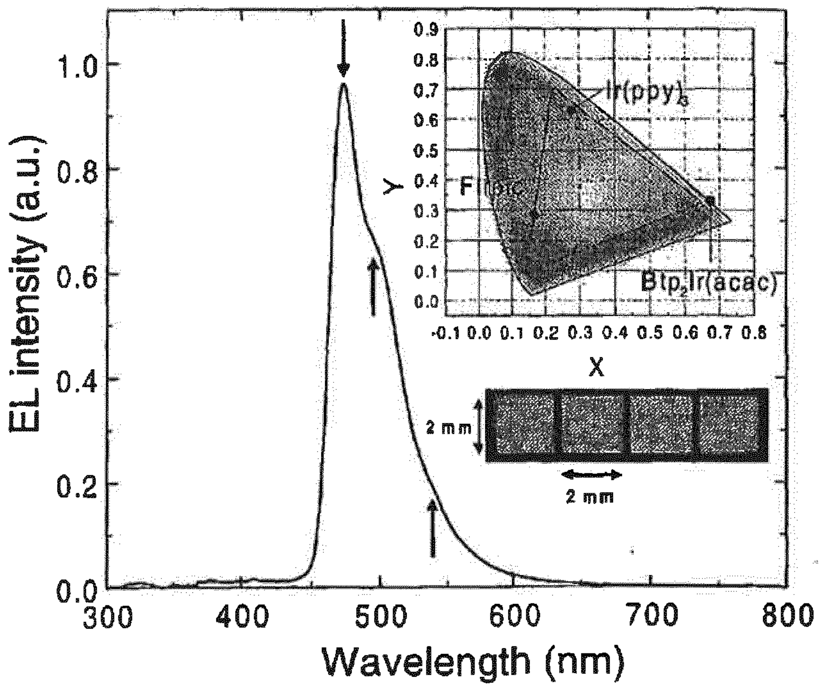
EL intensity (a.u.)
Wavelength (nm)
1.0
0.8
0.6
0.4
0.2
0.0
300
400
500
600
700
800
Y
X
Ir(ppy)3
Btp2Ir(acac)
2 mm
2 mm

Figure 1b:

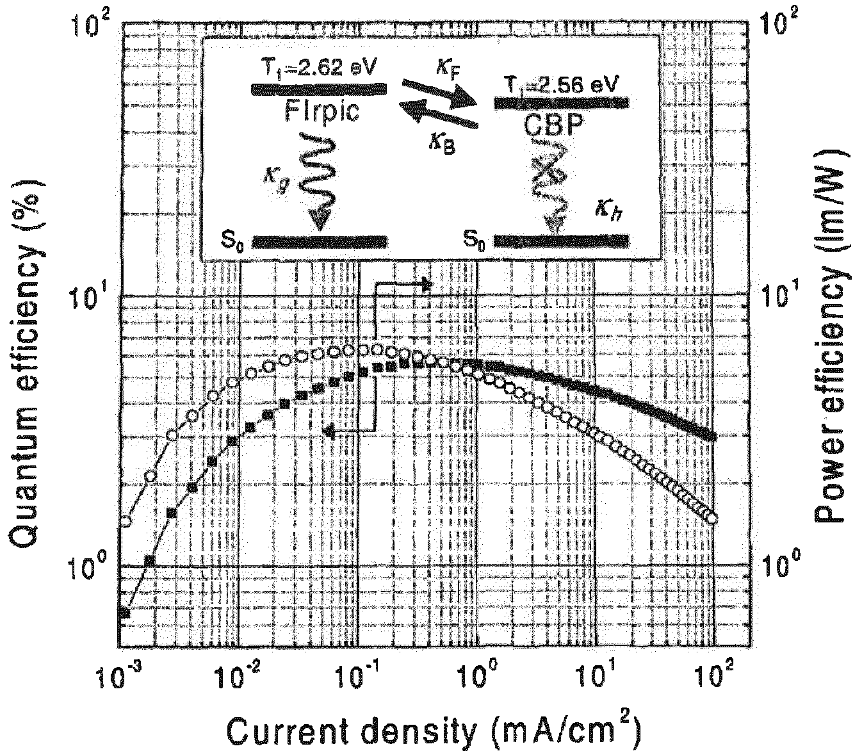
T1=2.62 eV
FIrpic
KF
KB
T1=2.56 eV
CBP
Kg
Kh
S0
S0
Quantum efficiency (%)
Power efficiency (lm/W)
Current density (mA/cm2)
10-3
10-2
10-1
100
101
102

Figure 2:

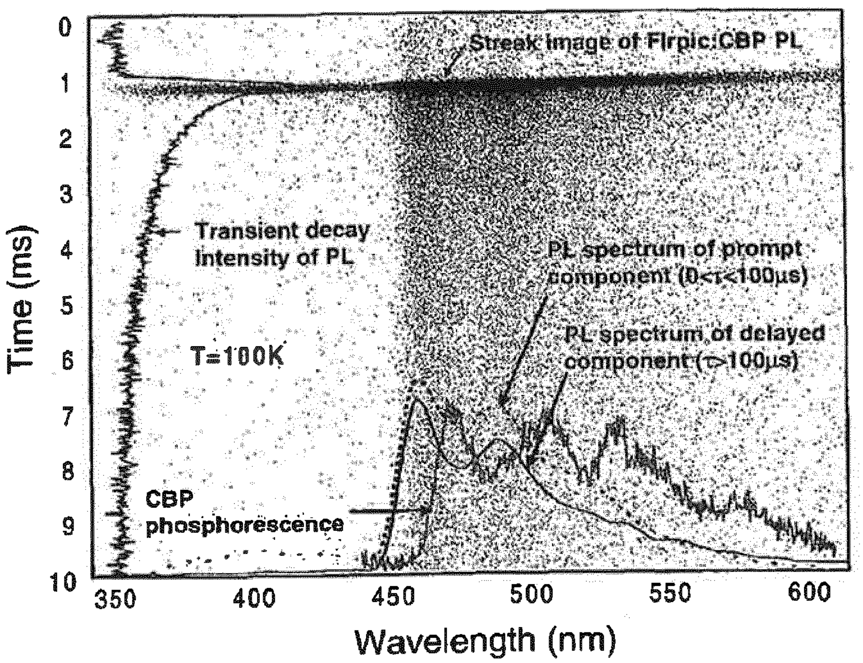
Streak image of FIrpic:CBP PL
Transient decay intensity of PL
T=100K
PL spectrum of prompt component (0<τ<100μs)
PL spectrum of delayed component (τ>100μs)
CBP phosphorescence
Time (ms)
0
1
2
3
4
5
6
7
8
9
10
350
400
450
500
550
600
Wavelength (nm)

Figure 3:

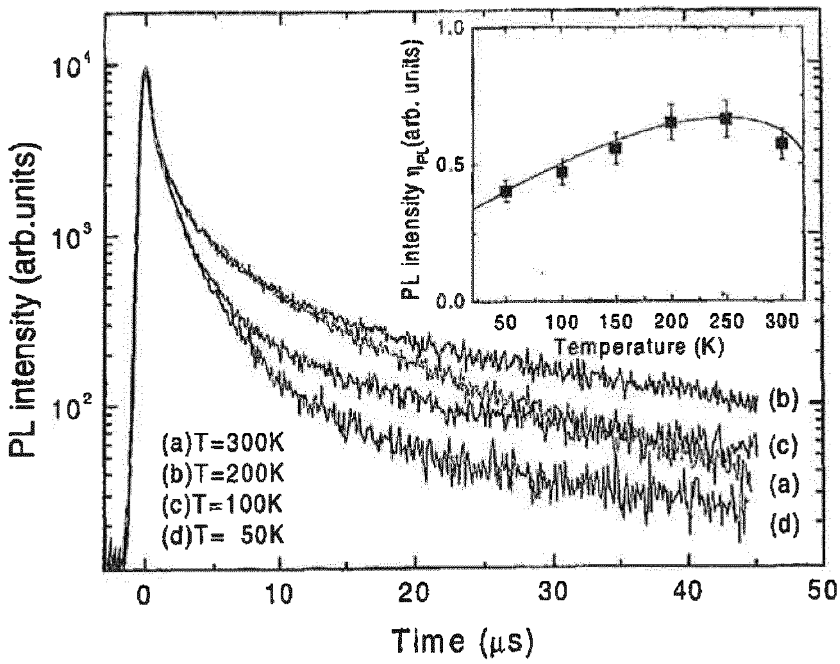
PL intensity (arb.units)
$10^4$
$10^3$
$10^2$
(a)T=300K
(b)T=200K
(c)T=100K
(d)T= 50K
(b)
(c)
(a)
(d)
0
10
20
30
40
50
Time (μs)
PL intensity $\eta_{PL}$(arb. units)
1.0
0.5
0.0
50
100
150
200
250
300
Temperature (K)

Figure 4:

Figure 7h

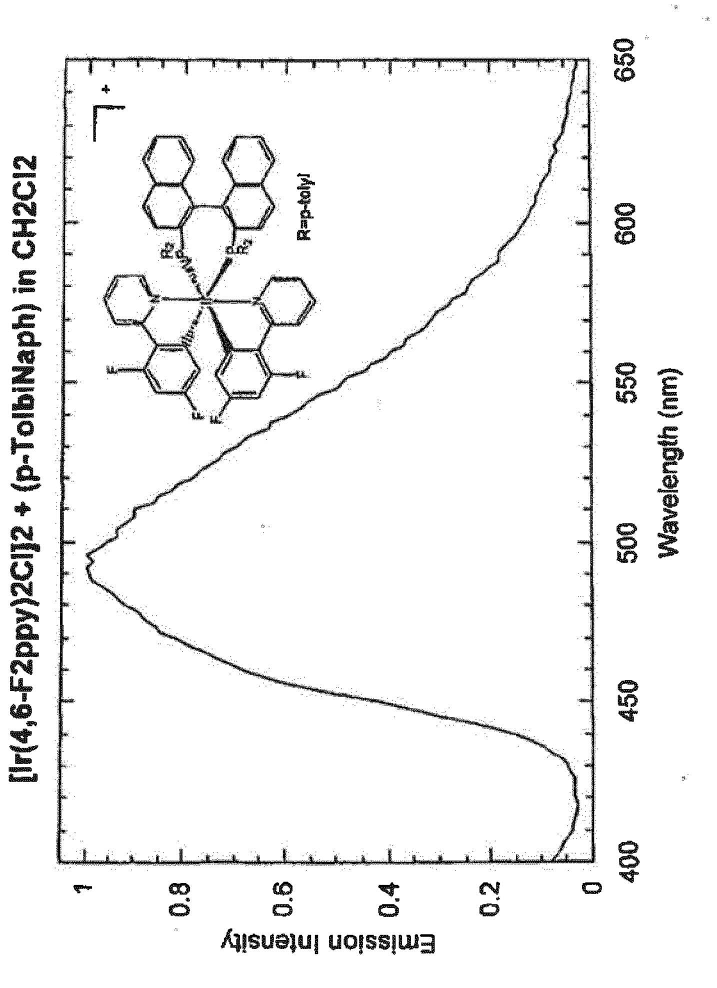
[Ir(4,6-F2ppy)2Cl]2 + (p-TolbiNaph) in CH2Cl2
Emission Intensity
0
0.2
0.4
0.6
0.8
1
400
450
500
550
600
650
Wavelength (nm)

Figure 7i

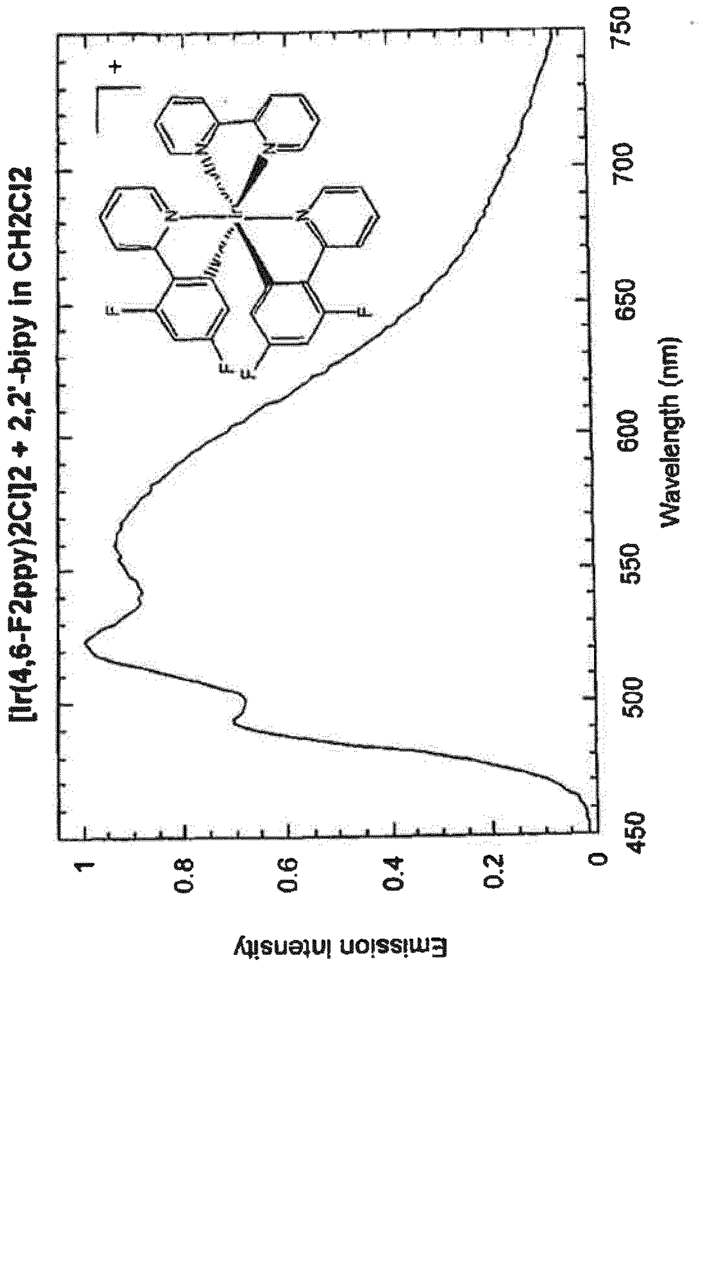
[Ir(4,6-F2ppy)2Cl]2 + 2,2'-bipy in CH2Cl2
Emission intensity
Wavelength (nm)
0
0.2
0.4
0.6
0.8
1
450
500
550
600
650
700
750

Figure 7j

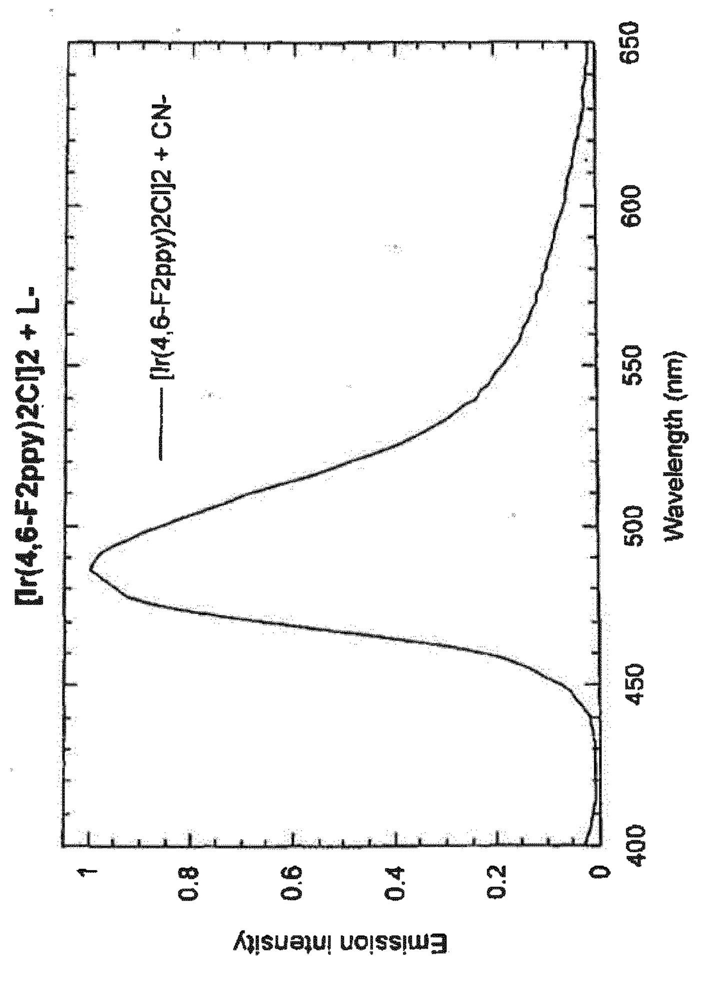
[Ir(4,6-F2ppy)2Cl]2 + L-
[Ir(4,6-F2ppy)2Cl]2 + CN-
Emission intensity
1
0.8
0.6
0.4
0.2
0
400
450
500
550
600
650
Wavelength (nm)

Figure 7k

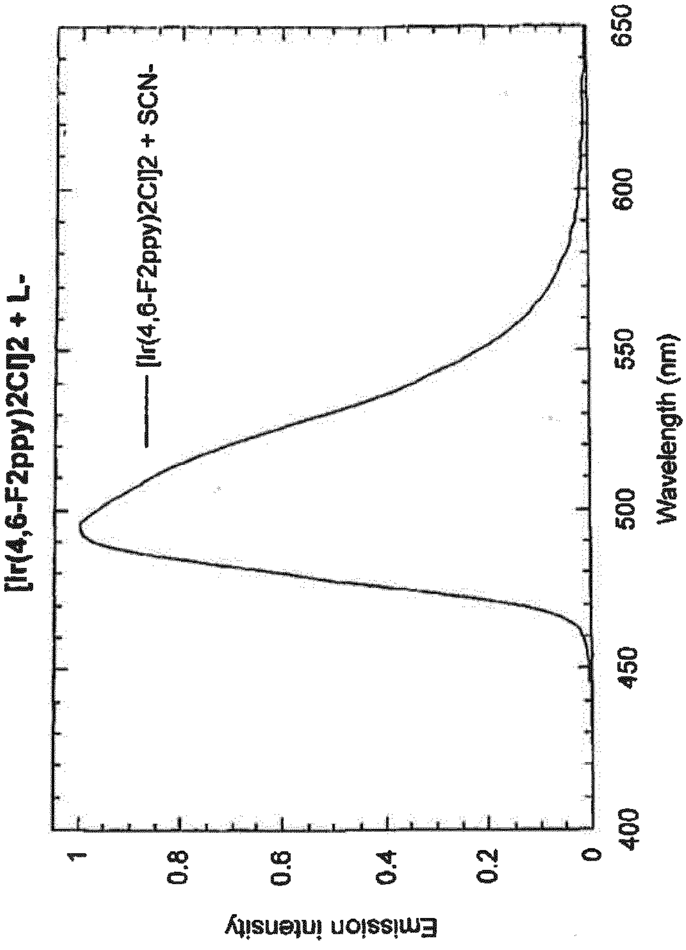
[Ir(4,6-F2ppy)2Cl]2 + L-
[Ir(4,6-F2ppy)2Cl]2 + SCN-
Emission intensity
1
0.8
0.6
0.4
0.2
0
400
450
500
550
600
650
Wavelength (nm)

Figure 7l

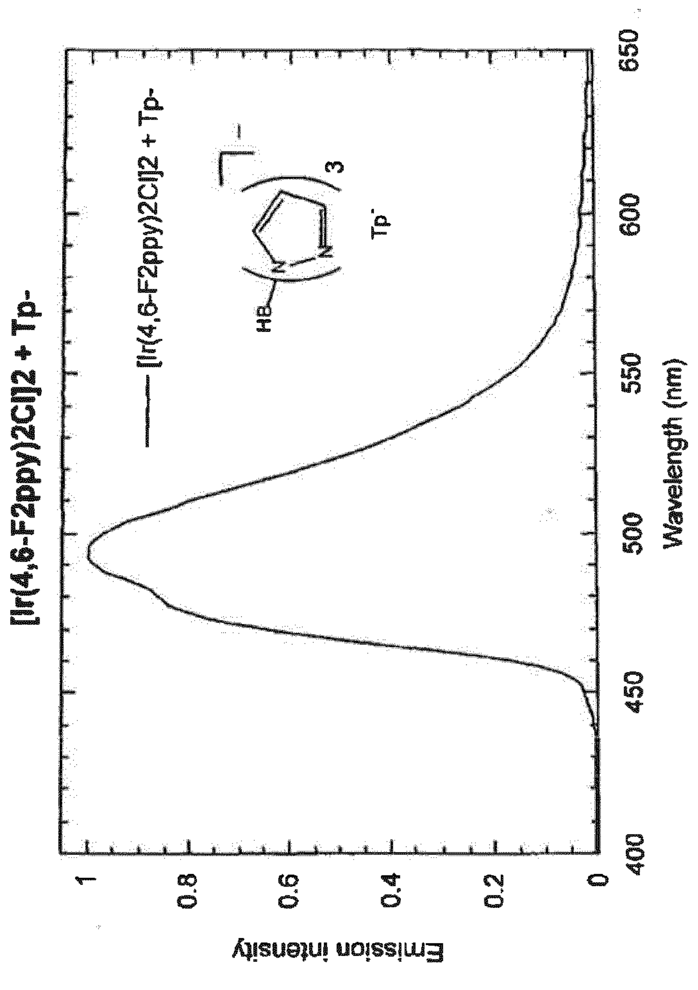
[Ir(4,6-F2ppy)2Cl]2 + Tp-
[Ir(4,6-F2ppy)2Cl]2 + Tp-
Tp-
Emission intensity
0
0.2
0.4
0.6
0.8
1
400
450
500
550
600
650
Wavelength (nm)

Figure 7m

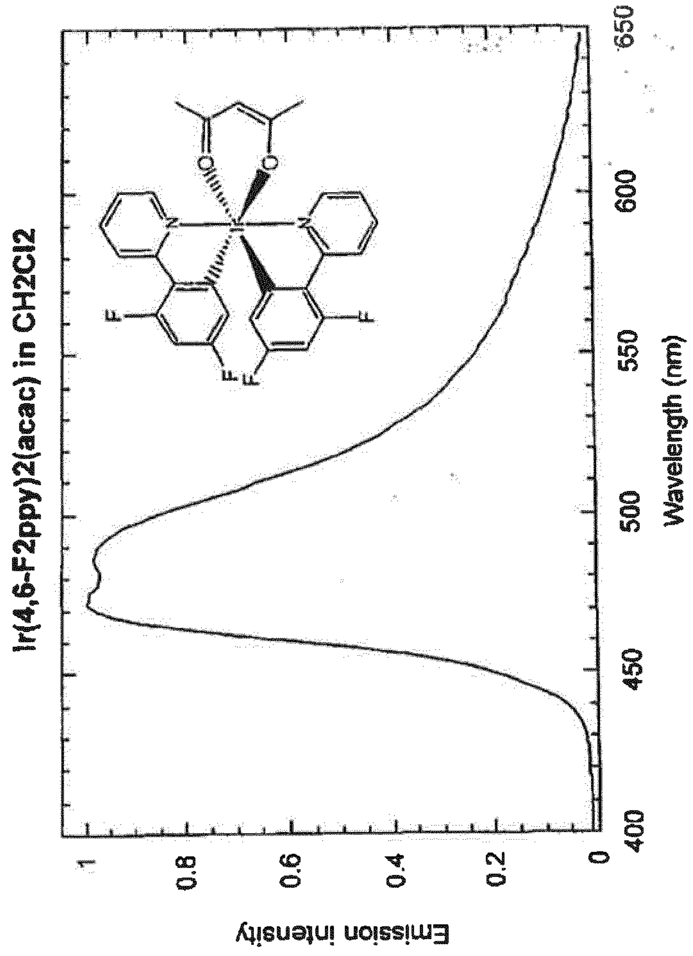
Ir(4,6-F2ppy)2(acac) in CH2Cl2
Emission intensity
0
0.2
0.4
0.6
0.8
1
400
450
500
550
600
650
Wavelength (nm)

Figure 7p

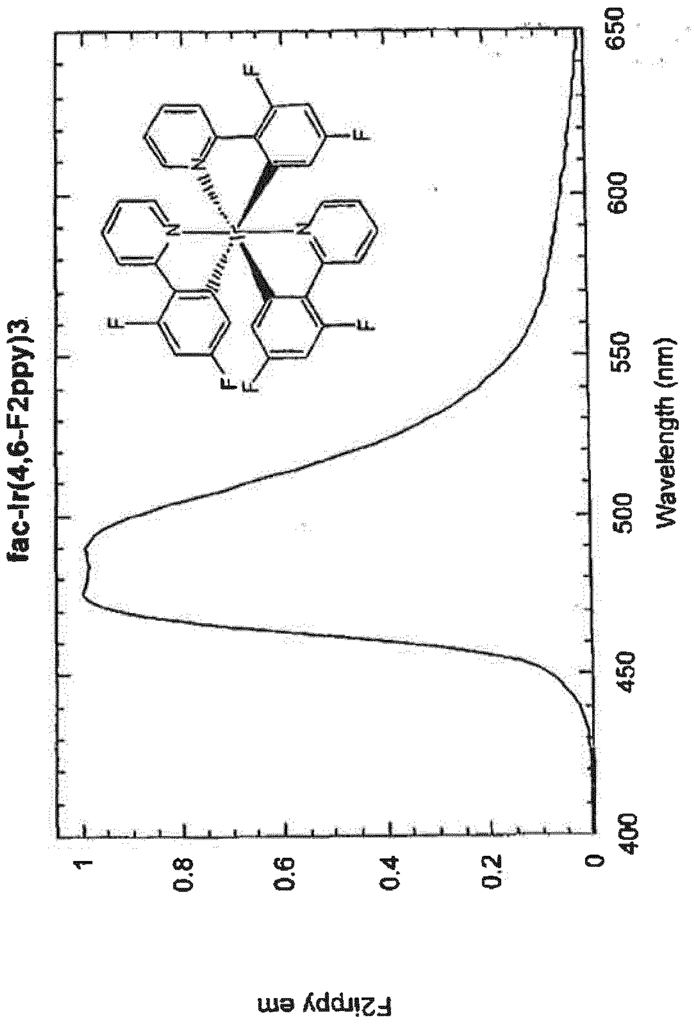
fac-Ir(4,6-F2ppy)3
F2irppy em
Wavelength (nm)
0
0.2
0.4
0.6
0.8
1
400
450
500
550
600
650

Figure 7q

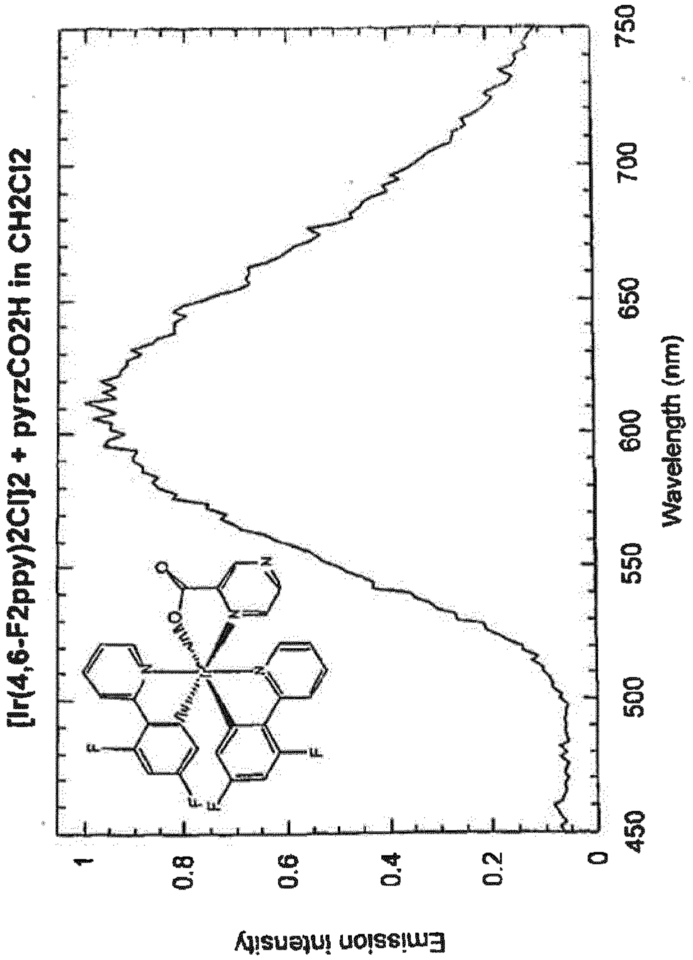
[Ir(4,6-F2ppy)2Cl]2 + pyrzCO2H in CH2Cl2
Emission intensity
0
0.2
0.4
0.6
0.8
1
450
500
550
600
650
700
750
Wavelength (nm)

Figure 7r

(4,5-F2ppz)2Ir(pic)

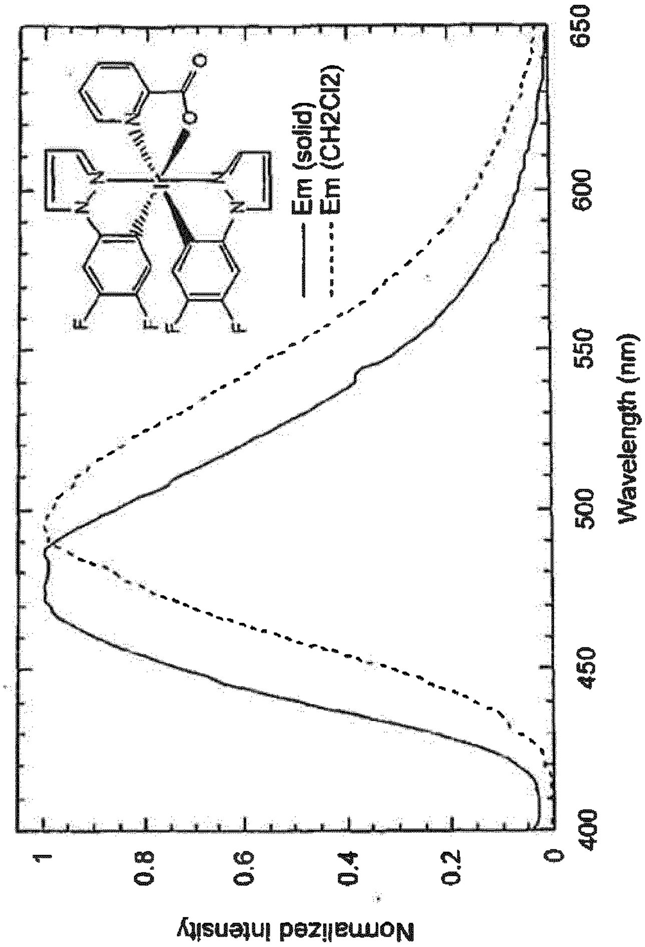

FIG. 17

PRB 62

HOSTS

(a) TPD

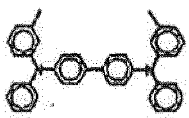

(b) BCP

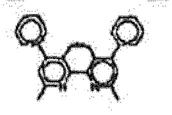

(c) CBP

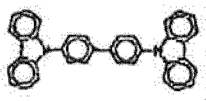

(d) $Alq_3$

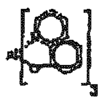

GUESTS

(e) $Ir(ppy)_3$

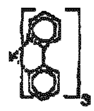

(f) PtOEP

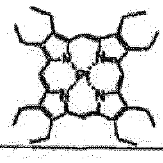

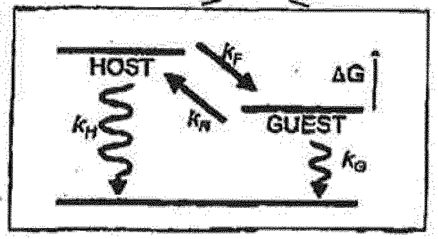

FIG. 18

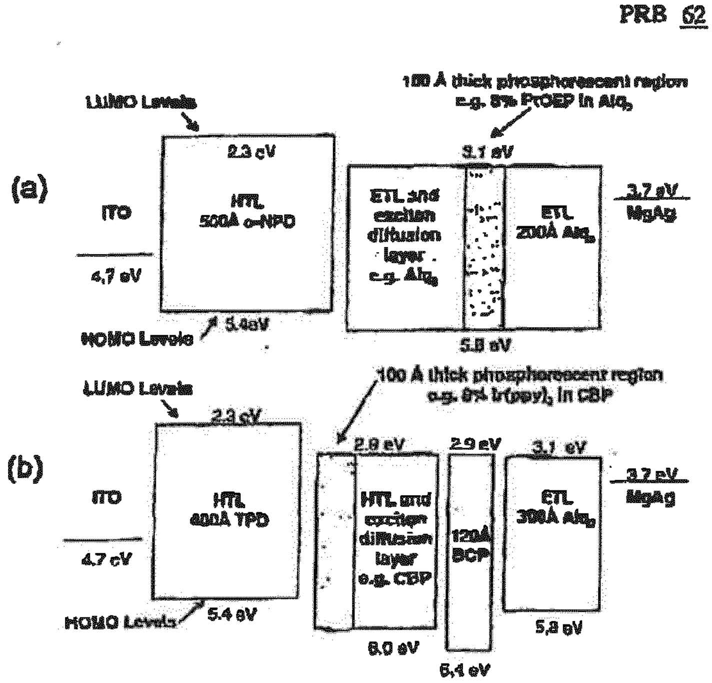
PRB 62
(a)
LUMO Levels
100 Å thick phosphorescent region
e.g. 8% PtOEP in $Alq_3$
2.3 eV
3.1 eV
ITO
HTL
500Å α-NPD
ETL and
exciton
diffusion
layer
e.g. $Alq_3$
ETL
200Å $Alq_3$
3.7 eV
MgAg
4.7 eV
HOMO Levels
5.4eV
5.8 eV
(b)
LUMO Levels
100 Å thick phosphorescent region
e.g. 8% $Ir(ppy)_3$ in CBP
2.3 eV
2.8 eV
2.9 eV
3.1 eV
ITO
HTL
400Å TPD
HTL and
exciton
diffusion
layer
e.g. CBP
120Å
BCP
ETL
300Å $Alq_3$
3.7 eV
MgAg
4.7 eV
HOMO Levels
5.4 eV
6.0 eV
6.4 eV
5.8 eV

FIG. 19

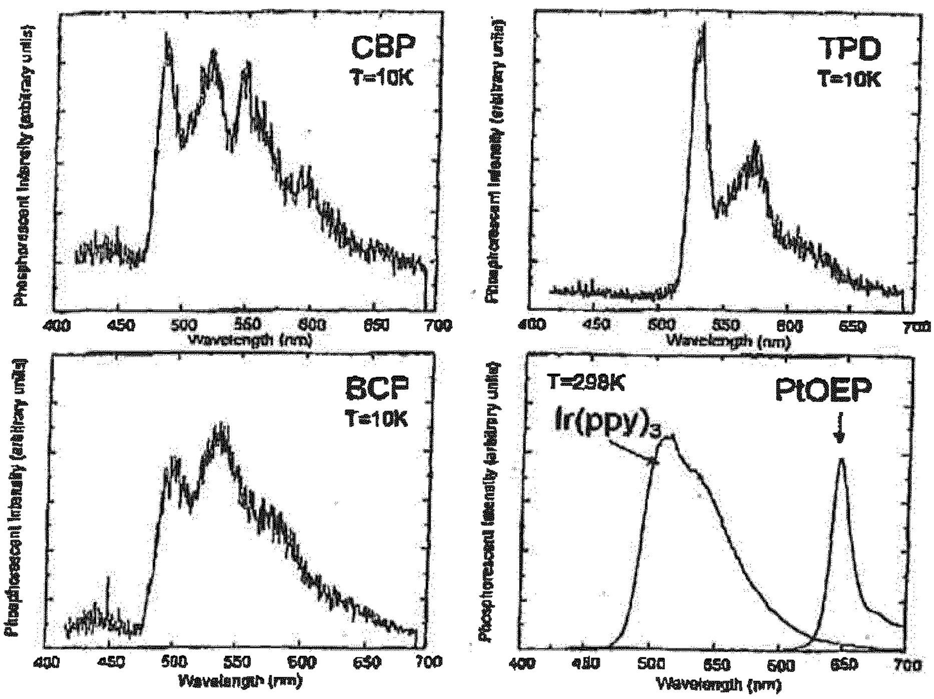
CBP
T=10K
TPD
T=10K
BCP
T=10K
T=298K
Ir(ppy)$_3$
PtOEP
Phosphorescent Intensity (arbitrary units)
Wavelength (nm)
400
450
500
550
600
650
700

FIG. 20

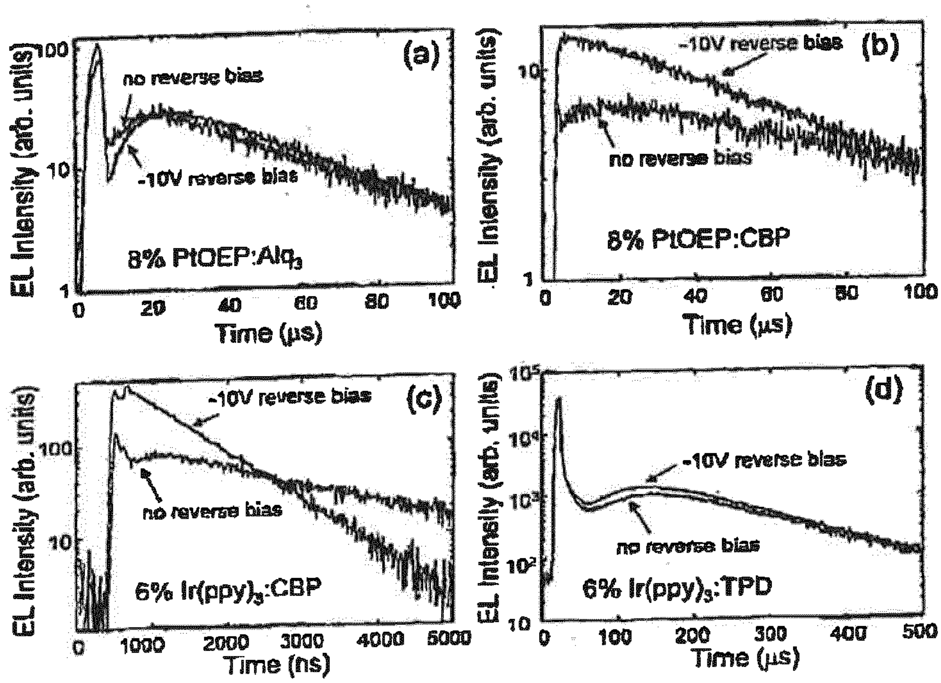
(a)
no reverse bias
-10V reverse bias
8% PtOEP:Alq3
EL Intensity (arb. units)
Time (μs)
(b)
-10V reverse bias
no reverse bias
8% PtOEP:CBP
EL Intensity (arb. units)
Time (μs)
(c)
-10V reverse bias
no reverse bias
6% Ir(ppy)3:CBP
EL Intensity (arb. units)
Time (ns)
(d)
-10V reverse bias
no reverse bias
6% Ir(ppy)3:TPD
EL Intensity (arb. units)
Time (μs)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **BALDO et al.** Highly Efficient Phosphorescent Emission from Organic Electroluminescent Devices. *Nature,* 1998, vol. 395, 151-154
- **BALDO, M. A. ; O'BRIEN, D. F. ; YOU, Y. ; SHOUSTIKOV, A. ; SIBLEY, S. ; THOMPSON, M. E. ; FORREST, S. R.** *Nature,* 1998, vol. 395, 151-154
- **BALDO, M. A. ; LAMANSKY, S. ; BURROWS, P. E. ; THOMPSON, M. E. ; FORREST, S. R.** *Appl. Phys. Lett.,* 1999, vol. 75, 4-6
- **ADACHI, C. ; BALDO, M. A. ; FORREST, S. R.** *App. Phys. Lett.,* 2000, vol. 77, 904-906
- **ADACHI, C. ; LAMANSKY, S. ; BALDO, M. A. ; KWONG, R. C. ; THOMPSON, M. E. ; FORREST, S. R.** *App. Phys. Lett.,* 2001, vol. 78, 1622-1624
- **ADACHI, C. ; BALDO, M. A. ; THOMPSON, M. E. ; FORREST, S. R.** *Bull. Am. Phys. Soc.,* 2001, vol. 46, 863
- **WILDE et al.** *J. Phys. Chem.,* 1991, vol. 95, 629-34
- **MIRCO et al.** *Inorg. Chem.,* 1993, vol. 32, 3081-7
- **MARCO et al.** *Adv. Mater.,* 1996, vol. 8 (7), 576-80
- **VANHELMONT et al.** *J. Chem. Soc., Dalton Trans.,* 1998, 2893-900
- **PAW et al.** *Coord. Chem. Rev.,* 1998, vol. 171, 125-50
- **CHE et al.** *Chem. Eur. J.,* 1999, vol. 5 (11), 3350-6
- **DJUROVICH et al.** *Polymer Preprints,* 01 March 2000, vol. 41 (1), 770-1
- **BALDO, M. A. ; O'BRIEN, D. F. ; THOMPSON, M. E. ; FORREST, S. R.** *Phys. Rev., B,* 1999, vol. 60, 14422-14428
- **FRIEND, R. H. ; GYMER, R. W. ; HOLMES, A. B. ; BURROUGHES, J. H. ; MARKS, R. N. ; TALIANI, C. ; BRADLEY, D. D. C. ; DOS SANTOS, D. A. ; BREDAS, J. L. ; LOGDLUND, M.** *Nature,* 1999, vol. 397, 121-128
- **CAO, Y ; PARKER, I. D. ; YU, G. ; ZHANG, C. ; HEEGER, A. J.** *Nature,* 1999, vol. 397, 414-417
- **BALDO, M. A. ; FORREST, S. R.** *Phys. Rev. B,* 2000, vol. 62, 10958-10966
- **FORD, W. E. ; RODGERS, M. A. J.** *J. Phys. Chem.,* 1992, vol. 96, 2917-2920
- **HARRIMAN, A. ; HISSLER, M. ; KHATYR, A. ; ZIESSEL, R.** *Chem. Commun.,* 1999, 735-736
- **LAMANSKY, S. ; DJUROVICH, P. ; MURPHY, D. ; ABDEL-RAZZAQ, F. ; ADACHI, C. ; BURROWS, P. E. ; FORREST, S. R. ; THOMPSON, M. E.** *J. Am. Chem. Soc.*
- **ADACHI, C. ; BALDO, M. A. ; THOMPSON, M. E. ; FORREST, S. R.** *Material Research Society,* 1999
- **WU, Q. G. ; LAVIGNE, J. A. ; TAO, Y. ; D'IORIO, M. ; WANG, S. N.** *Inorg. Chem.,* 2000, vol. 39, 5248-5254
- **MA, Y. G. ; LAI, T. S. ; WU, Y.** *Adv. Mat.,* 2000, vol. 12, 433-435
- **GRICE, A. W. ; BRADLEY, D. D. C. ; BERNIUS, M. T. ; INBASEKARAN, M. ; WU, W. W. ; WOO, E. P.** *Appl. Phys. Lett.,* 1998, vol. 73, 629-931
- **HOSOKAWA, C. ; HIGASHI, H. ; NAKAMURA, H. ; KUSUMOTO, T.** *Appl. Phys. Lett.,* 1995, vol. 67, 3853-3855
- **HOSOKAWA, C. ; EIDA, M. ; MATSUURA, M. ; FUKUOKA, K. ; NAKAMURA, H. ; KUSUMOTO, T.** *Synth. Met.,* 1997, vol. 91, 3-7
- **KING, K. A. ; SPELLANE, P. J. ; WATTS, R. J.** *J. Am. Chem. Soc.,* 1985, vol. 107, 1431-1432
- **LAMANSKY, S. ; DJUROVICH, P. ; MURPHY, D. ; ABDEL-RAZZAQ, F. ; KWONG, R. ; TSYBA, L ; BORTZ, M. ; MUI, B. ; BAU, R. ; MARK E.** *Inorganic Chemistry,* 2001, vol. 40, 1704-1711
- **ADACHI, C. ; BALDO, M. A. ; FORREST, S. R.** *J. Appl. Phys.,* 2000, vol. 87, 8049-8055
- **BALDO, M. A. ; ADACHI, C. ; FORREST, S. R.** *Phys. Rev. B,* 2000, vol. 62, 10967-10977
- **ADACHI, C. ; KWONG, R. C. ; FORREST, S. R.** *Organic Electronics,* 2001, vol. 2
- **M. A. BALDO et al.** *Nature,* 1998, vol. 395, 151
- **D. F. O'BRIEN et al.** *Appl. Phys. Lett.,* 1999, vol. 74, 442
- **M. A. BALDO et al.** *Appl. Phys. Lett.,* 1999, vol. 75, 4
- **T. TSUTSUI et al.** *Japanese. J. Appl. Phys.,* 1999, vol. 38, L1502
- **C. ADACHI et al.** *App. Phys. Lett.,* 2000, vol. 77, 904
- **M. J. YANG et al.** *Japanese J. Appl. Phys.,* 2000, vol. 39, L828
- **C. L. LEE et al.** *Appl. Phys. Lett.,* 2000, vol. 77, 2280
- **M.A. BALDO et al.** *Appl. Phys. Lett.,* 1999, vol. 75, 4

- **SHIROTA et al.** *Appl. Phys. Lett.,* 1994, vol. 65 (7), 807
- **M. A. BALDO ; S.R. FORREST.** *Physical Review B,* 2000, vol. 62 (16